(19) Europäisches Patentamt
European Patent Office
Office européen des brevets

(11) EP 2 256 526 A1

# (12) EUROPEAN PATENT APPLICATION

published in accordance with Art. 153(4) EPC

(43) Date of publication:
**01.12.2010 Bulletin 2010/48**

(21) Application number: **08872532.0**

(22) Date of filing: **19.12.2008**

(51) Int Cl.:
***G02B 5/20*** (2006.01)

(86) International application number:
**PCT/JP2008/073162**

(87) International publication number:
**WO 2009/104339 (27.08.2009 Gazette 2009/35)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **20.02.2008 JP 2008038658**

(71) Applicant: **FUJIFILM Corporation**
**Tokyo 106-8620 (JP)**

(72) Inventor: **YOSHIBAYASHI, Mitsuji**
**Haibara-gun**
**Shizuoka 421-0396 (JP)**

(74) Representative: **HOFFMANN EITLE**
**Patent- und Rechtsanwälte**
**Arabellastrasse 4**
**81925 München (DE)**

## (54) COLOR FILTER, METHOD FOR PRODUCING THE SAME, AND SOLID-STATE IMAGING DEVICE

(57) A method for producing a color filter in such a manner that a first color pattern is formed in a stripe shape on a support, a second color layer is formed on the support on which the above-mentioned first color pattern has been formed, an area for forming a third color pattern in the above-mentioned first color pattern and/or the above-mentioned second color layer is removed by dry etching, and the third color pattern is formed in the area, from where the above-mentioned first color pattern and the above-mentioned second color layer have been removed, on the above-mentioned support.

FIG.15A

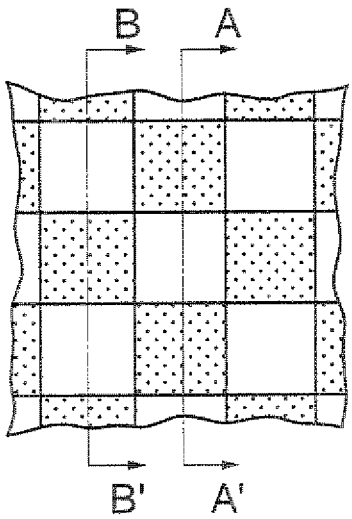


EP 2 256 526 A1

FIG.15B

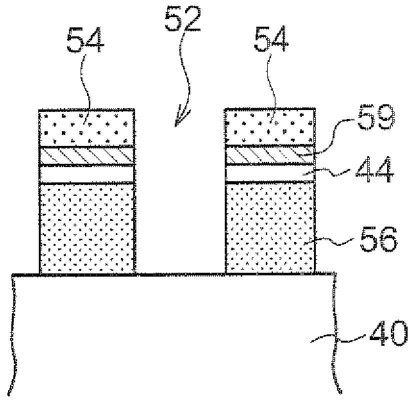


FIG.15C

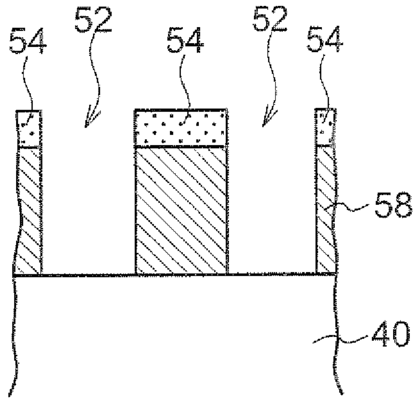

**Description**

Technical Field

The invention relates to a color filter, a method for producing the same, and a solid-state imaging device.

Background Art

In recent years, the so-called photolithographic method has been used as a method for producing a color filter from the viewpoint of production costs and ease of production.
The photolithographic method herein is a method for producing a color filter in such a manner that a radiosensitive composition such as a color curable composition is applied and dried on a substrate by a spin coater, a roll coater and the like to form a coating film, which is subjected to pattern exposure, development and baking thereby form a color pixel, and this process is repeated in each color.
The photolithographic method is so high in location accuracy as to be widely utilized as an appropriate method for producing a color filter for a large-screen and high-definition color display.
A technique of using a negative photosensitive composition such that a photopolymerizable monomer and a photopolymerization initiator are used together for alkali-soluble resin is known as a technique with regard to the above-mentioned photolithographic method (for example, refer to Patent Documents 1 to 4).
Here, a general summary of a method for producing a conventional color filter by the photolithographic method is described while referring to Figs. 20 to 24.
As shown in Fig. 20, for example, a negative color curable composition is applied on a support 100 by using a spin coater to form a first color layer 102. After being subjected to prebake, the first color layer is subjected to pattern exposure through a photomask 107 as shown in Fig. 21 (that is, a first color pixel forming area 104 in the first color layer is exposed to ultraviolet-light irradiation), and thereafter an unnecessary area 106 in the first color layer is removed by developing processing and is further subjected to postbake to form a first color pixel 108 as shown in Fig. 22.
A second color pixel 110 shown in Fig. 23 and a third color pixel 112 shown in Fig. 24 are each formed by further repeating the same process as the process in forming the first color pixel to form a color filter.
In the above-mentioned method for producing a conventional color filter by the photolithographic method, as shown in Fig. 24A, a problem is caused that an area 114 with no color pixels formed occurs in an area in which corners of each color pixel come together. Also, a problem is that a desired film thickness is not obtained in each color pixel. In addition, a problem is caused that the film thickness of an area in which color pixels contact with each other is not formed as assumed (that is, as shown in Fig. 24B, a spot 116 where a film thickness of color pixels is thin occurs in the vicinity of the boundary line between color pixels).
The studies such as the optimization of mask bias and the improvement of curing efficiency for an exposure light source of a color curable composition have been made as measures against these problems; however, there is a limitation.
A technique of embedding the second color pixel by heat flow (reflow) in heat curing is also known (for example, refer to Patent Documents 5 and 6); however, this technique is a technique which is easily dependent on performance and process conditions of a color curable composition used for forming the second color pixel or later, and the problem is that the heating distribution of a support is directly reflected in embeddability, for example.
In addition, the contraction of an image size progresses in a liquid crystal display device and a solid-state imaging device, and the necessity to contract a color filter is also caused in accordance therewith. In particular, the micronization of a solid-state imaging device is so remarkable as to require a high-resolution technique for less than 2.0 μm; however, the conventional photolithographic method is reaching a limitation in view of resolving power. Thus, the above-mentioned problems of the photolithographic method become increasingly remarkable.
A technique of using dye is also proposed as a technique for corresponding to further micronization and higher definition in a color filter for a solid-state imaging device.
However, a curable composition containing dye is generally inferior to pigment in performance of light resistance, thinner film and ease of modification in transmission spectral characteristics, for example. In particular, in the case of being used for producing a color filter for a solid-state imaging device, a film thickness of 1.0 μm or less tends to be required, so that a large amount of colorant needs to be added to a curable composition; thus, the problems are that adhesion to a substrate becomes insufficient, sufficient curing is not obtained, dye fades away also in an exposure portion, and pattern forming is remarkably difficult.
With respect to the above-mentioned method for producing a color filter by utilizing the photolithographic method, a dry etching method has been long known as an effective method for forming a thinner film and a finer pattern. The dry etching method has been conventionally adopted as a method for rectangularly forming a pattern. A method for forming a pattern, such that the photolithographic method and the dry etching method are combined, has been also proposed

(for example, refer to Patent Document 7).

[Patent Document 1] Japanese Patent Application Laid-Open (JP-A) No. 2-181704
[Patent Document 2] JP-A No. 2-199403
[Patent Document 3] JP-A No. 5-273411
[Patent Document 4] JP-A No. 7-140654
[Patent Document 5] JP-A No. 2006-267352
[Patent Document 6] JP-A No. 2006-292842
[Patent Document 7] JP-A No. 2001-249218

Disclosure of the invention

Problems to be Solved by the Invention

However, in the technique described in the above-mentioned Patent Document 7, though the first color pixel may be rectangularly formed, the formation of the second and third color pixels is determined in rate by the performance of a conventional photosensitive color composition to leave the above-mentioned problems of the photolithographic method.
Accordingly, in order to solve these problems by the photolithographic method, coloring agent concentration needs to be raised while making the discrimination of solubility by exposure and development, so that a technical hurdle is very high.
As described above, the method for producing a conventional color filter offered a limitation (lower limitation) in formable pattern size.
The invention has been made in view of the above and the problem thereof is to achieve the following object.
That is to say, an object of the invention is to provide a method for producing a color filter, such that pattern formation limitation is improved and a finer pattern may be formed.
Also, an object of the invention is to provide a color filter excellent in rectangularity of a color pixel.
Further, an object of the invention is to provide a solid-state imaging device excellent in color reproducibility.

Means for Solving the Problem

The inventors of the invention have completed the invention by finding out that the case where a repeating pattern (such as a striped pattern) is first formed and the repeating pattern is subsequently made into an isolated pattern to form a color pixel allows the color pixel to be formed so that a cross section thereof becomes closer to that of a rectangle, as compared with the case where an isolated pattern is directly formed to form a color pixel.
That is to say, specific means for solving the above-mentioned problems are as follows.
<1> A method for producing a color filter including

(a) a step of forming a first color pattern in a stripe shape on a support;
(b) a step of forming a second color layer on the support on which the first color pattern has been formed;
(c) a step of removing an area for forming a third color pattern in the first color pattern and/or the second color layer by dry etching; and
(d) a step of forming the third color pattern in the area, from where the first color pattern and/or the second color layer have been removed, on the support.

<2> The method for producing a color filter of <1>, wherein formation of the first color pattern is performed by a method for forming a first color layer on the support and exposing and developing the formed first color layer, or a method for forming a first color layer on the support to form a resist pattern on the formed first color layer by using a photoresist and dry-etching the first color layer by using the formed resist pattern as an etching mask.
<3> The method for producing a color filter of <1> or <2>, wherein:

formation of the third color pattern is performed by a method for forming a third color layer on the support after (c) the step of removing, and exposing and developing the formed third color layer; and
the method further comprises a step of flattening at least the formed third color pattern and the second color layer where the area for forming the third color pattern has been removed.

<.4> The method for producing a color filter of <1> or <2>, wherein formation of the third color pattern is performed by forming a third color layer on the support after (c) the step of removing, and flattening at least the formed third color layer and the second color layer where the area for forming the third color pattern has been removed.

<5> The method for producing a color filter of any one of <1> to <4>, wherein the step of flattening is an etch back treatment that etches the whole exposed plane of the formed color layer and/or a polishing treatment that polishes the whole exposed plane of the formed color layer.

<6> The method for producing a color filter of any one of <3> to <5>, wherein the step of forming the first color pattern (a) includes a step of forming a first color layer on the support and a step of forming a stopper layer on the formed first color layer;
in the step of removing (c), the area for forming the third color pattern in the first color pattern and/or the second color layer is removed together with an area for forming the third color pattern in the stopper layer; and
in the flattening step, flattening is performed until the stopper layer is exposed.

<7> A color filter that is formed by using the method of any one of <1> to <6>-<8> A solid-state imaging device that includes the color filter of <7>.

Effects of the Invention

The invention may provide a method for producing a color filter, such that pattern formation limitation is improved and a finer pattern may be formed.
Further, the invention may provide a color filter excellent in rectangularity of a color pixel.
Further, the invention may provide a solid-state imaging device excellent in color reproducibility.

Brief Description of the Drawings

Fig. 1A is a plan view showing a first exemplary embodiment.
Fig. 1B is an A-A' line cross-sectional view in Fig. 1A.
Fig. 2A is a plan view showing a first exemplary embodiment.
Fig. 2B is an A-A' line cross-sectional view in Fig. 2A.
Fig. 3A is a plan view showing a first exemplary embodiment.
Fig. 3B is an A-A' line cross-sectional view in Fig. 3A.
Fig. 4A is a plan view showing a first exemplary embodiment.
Fig. 4B is an A-A' line cross-sectional view in Fig. 4A.
Fig. 4C is a B-B' line cross-sectional view in Fig. 4A.
Fig. 5A is a plan view showing a first exemplary embodiment.
Fig. 5B is an A-A' line cross-sectional view in Fig. 5A.
Fig. 5C is a B-B' line cross-sectional view in Fig. 5A.
Fig. 6A is a plan view showing a first exemplary embodiment.
Fig. 6B is an A-A' line cross-sectional view in Fig. 6A.
Fig. 6C is a B-B' line cross-sectional view in Fig. 6A.
Fig. 7A is a plan view showing a first exemplary embodiment.
Fig. 7B is an A-A' line cross-sectional view in Fig. 7A.
Fig. 7C is a B-B' line cross-sectional view in Fig. 7A.
Fig. 8A is a plan view showing a first exemplary embodiment.
Fig. 8B is an A-A' line cross-sectional view in Fig. 8A.
Fig. 8C is a B-B' line cross-sectional view in Fig. 8A.
Fig. 9A is a plan view showing a second exemplary embodiment.
Fig. 9B is an A-A' line cross-sectional view in Fig. 9A.
Fig. 10A is a plan view showing a second exemplary embodiment.
Fig. 10B is an A-A' line cross-sectional view in Fig. 10A.
Fig. 11A is a plan view showing a second exemplary embodiment.
Fig. 11B is an A-A' line cross-sectional view in Fig. 11A.
Fig. 12A is a plan view showing a second exemplary embodiment.
Fig. 12B is an A-A' line cross-sectional view in Fig. 12A.
Fig. 13A is a plan view showing a second exemplary embodiment.
Fig. 13B is an A-A' line cross-sectional view in Fig. 13A.
Fig. 14A is a plan view showing a second exemplary embodiment.
Fig. 14B is an A-A' line cross-sectional view in Fig. 14A.
Fig. 14C is a B-B' line cross-sectional view in Fig. 14A.
Fig. 15A is a plan view showing a second exemplary embodiment.

Fig. 15B is an A-A' line cross-sectional view in Fig. 15A.
Fig. 15C is a B-B' line cross-sectional view in Fig. 15A.
Fig. 16A is a plan view showing a second exemplary embodiment.
Fig. 16B is an A-A' line cross-sectional view in Fig. 16A.
Fig. 16C is a B-B' line cross-sectional view in Fig.16A.
Fig. 17A is a plan view showing a second exemplary embodiment.
Fig. 17B is anA-A' line cross-sectional view in Fig. 17A.
Fig. 17C is a B-B' line cross-sectional view in Fig. 17A.
Fig. 18A is a plan view showing a second exemplary embodiment.
Fig. 18B is an A-A' line cross-sectional view in Fig. 18A.
Fig. 18C is a B-B' line cross-sectional view in Fig. 18A.
Fig. 19 is a plan view showing another exemplary embodiment.
Fig. 20A is a plan view showing a method for producing a conventional color filter.
Fig. 20B is an A-A' line cross-sectional view in Fig. 20A.
Fig. 21 A is a plan view showing a method for producing a conventional color filter.
Fig. 21B is anA-A' line cross-sectional view in Fig. 21A.
Fig. 22A is a plan view showing a method for producing a conventional color filter.
Fig. 22B is an A-A' line cross-sectional view in Fig. 22A.
Fig. 23A is a plan view showing a method for producing a conventional color filter.
Fig. 23B is an A-A' line cross-sectional view in Fig. 23A.
Fig. 24A is a plan view showing a method for producing a conventional color filter.
Fig. 24B is a B-B' line cross-sectional view in Fig. 24A.

Best Mode for Carrying out the Invention

A method for producing a color filter of the invention includes (a) the first color pattern forming step that forms a first color pattern in a stripe shape on a support, (b) the second color layer forming step that forms a second color layer on the support on which the above-mentioned first color pattern has been formed, (c) the removing step that removes an area for forming a third color pattern in the above-mentioned first color pattern and/or the above-mentioned second color layer by dry etching, and (d) the third color pattern forming step that forms the third color pattern in an area, from where the above-mentioned first color pattern and/or the above-mentioned second color layer have been removed, on the above-mentioned support.

Generally, with regard to pattern formation in photolithography, as compared with an isolated pattern, a repeating pattern such as a striped pattern offers high edge contrast and the pattern may be formed so that a cross section thereof becomes a shape closer to that of a rectangle. In the invention, a cross section of the pattern signifies a cross section when the pattern is cut by a plane parallel to an axis in the axis direction of the pattern and perpendicular to a support. When the pattern is formed in a stripe shape, the contrast in a longer direction of the pattern is constant and a sign that a corner of the pattern is rounded off is not caused. Through this property, the first color pattern in stripe is formed by a photolithographic method, so that the contrast in a direction perpendicular to the above-mentioned longer direction may be improved to maintain rectangularity of the pattern cross section and exclude an influence of optical proximity in the above-mentioned longer direction. The first color pattern in stripe may be formed by using dry etching, in which case the cross section may be formed into a shape closer to that of a rectangle than the case of forming by a photolithographic method.

In addition, the method for producing a color filter of the invention is composed so that after the first color pattern is formed in a stripe shape, the second color layer is formed on the support on which the above-mentioned first color pattern has been formed, and thereafter an area for forming the third color pattern in the first color pattern and/or the second color layer is removed by dry etching to form a recess, and then the third color pattern is embedded in the recess. Such a composition allows the step of forming an isolated pattern to be decreased and allows an influence of light intensity distribution to be restrained (distortion of the pattern to be restrained).

According to the above, the method for producing a color filter of the invention allows pattern forming to be improved. Specifically, a phenomenon such that an area with no color pixels formed occurs in an area in which corners of each color pixel come together may be restrained, and a phenomenon such that a spot where a film thickness of color pixels is thin occurs in the vicinity of the boundary line between color pixels may be restrained. As a result, particularly in a photolithographic method, pattern formation limitation in the case of forming a color pattern may be improved, and a color filter having a finer pixel may be produced.
In addiction, in the method for producing a color filter of the invention, an embodiment of forming a color pattern of all colors (such as all of the first to the third color patterns) by dry etching is also appropriate, by which embodiment pattern forming and pattern formation limitation may be further improved.

In the invention, for convenience of description, a color film formed without partitioning areas (the so-called solid film) is defined as 'color layer', and a color film formed while partitioning areas into a pattern (such as a film patterned in a stripe shape) is defined as 'color pattern'. Here, an embodiment of forming while partitioning areas into a pattern (an embodiment of patterning) includes an embodiment of patterning a photosensitive color film by pattern exposure and development as well as an embodiment of patterning a color film by forming a resist pattern on the color film to etch the resist pattern as an etching mask, and an embodiment of patterning by forming a color film so as to be embedded in a patterned recess provided on a support and removing a portion lying out of the recess in the formed color film.
Among the above-mentioned color patterns, a color pattern as an element for composing a color filter array (such as a color pattern patterned into a square) is defined as 'color pixel'.
Each step and specific exemplary embodiments of the method for producing a color filter of the invention are hereinafter described to subsequently describe dry etching, support, color pattern, photoresist and stopper layer.

<First color pattern forming step>

The first color pattern forming step is a step that forms a first color pattern in a stripe shape on a support.
A method for forming the first color pattern is not particularly limited and is appropriately (1) a method for forming a color layer on a support including exposing and developing the formed color layer (also referred to as 'a photolithographic method' in the invention), or (2) a method for forming a color layer on a support including forming a resist pattern on the formed color layer by using a photoresist and then dry-etching the color layer by using the formed resist pattern as an etching mask (also referred to as 'a dry etching method' in the invention).

] <Second color layer forming step>

The second color layer forming step is a step that forms a second color layer on the support on which the above-mentioned first color pattern has been formed. Here, the second color layer is formed so as to cover the first color pattern and be embedded in an area put between the first color patterns on the support (for example, refer to a red color layer 16 in Fig. 3 or a blue color layer 50 in Fig. 13).
In addition, the formed second color layer is patterned by removing an area for forming a third color pattern in the second color layer in the after-mentioned step of removing. In the invention, the second color layer where the area for forming the third color pattern has been removed is occasionally referred to as 'second color pattern' (for example, refer to a red color pixel 24 and a red pattern 25 in Fig. 5 or a blue color pixel 58 and a blue pattern 59 in Fig. 15).

<Third color pattern forming step>

The third color pattern forming step is a step that forms a third color pattern in an area, from where the first color pattern and/or the second color layer have been removed by dry etching in the after-mentioned step of removing.
In the invention, the second color pattern laminated on the first color pattern is preferably removed in the same step as the third color pattern forming step or after the third color pattern forming step.
Examples of a method for forming the third color pattern include the above-mentioned (1) photolithographic method and (2) dry etching method, and also appropriately includes (3) a method for forming a color layer on the support with the color pattern formed to subject the formed color layer to flattening treatment (also referred to as 'a flattening method' in the invention).
Specific embodiments of the above-mentioned flattening treatment are appropriately an embodiment of forming a color layer so as to embed a color resin composition in a recess on a support put between (or surrounded by) the color patterns to subject the whole exposed plane of the formed color layer to treatments such as etching and/or polishing and thereby remove an excessive portion lying out of the above-mentioned recess in the formed color layer.
The above-mentioned flattening treatment is preferably etch back treatment of dry-etching the whole exposed plane of the color layer (or color pattern) from the viewpoint of the simplification of production process and production costs.
In addition, the above-mentioned flattening treatment is not limited to the etch back treatment, and is also preferably polishing treatment such as Chemical Mechanical Polishing (hereinafter referred to as 'CMP') treatment of polishing the whole exposed plane of the formed second and third color layer chemically and mechanically.
Specific embodiments of forming the third color pattern by the above-mentioned (1) photolithographic method include an embodiment of forming the third color layer on the support after the after-mentioned removing step to obtain the third color pattern by exposing and developing the formed third color layer. It is preferable that this embodiment further has at least the step of flattening the formed third color pattern and the second color layer (the second color pattern) where the area for forming the above-mentioned third color pattern has been removed.
In the above-mentioned flattening treatment, it is more preferable that the second color pattern laminated on the first color pattern is removed.

The details of the flattening treatment are as described above.

Specific embodiments of forming the third color pattern by the above-mentioned (2) dry etching method include an embodiment of forming the third color layer on the support after the after-mentioned removing step to form a resist pattern on the formed third color layer by using a photoresist and obtain the third color pattern by dry-etching the third color layer while using the formed resist pattern as an etching mask. In the case of the above-mentioned dry-etching, the third color layer as well as the second color pattern laminated on the first color pattern is removed more preferably by over-etching. In the case of this embodiment, irregularities are occasionally caused on the surface of the formed color filter, and yet further performance of the flattening treatment allows the irregularities to be flattened.

The details of the flattening treatment are as described above.

Specific embodiments of forming the third color pattern by the above-mentioned (3) flattening method are appropriately an embodiment of forming the third color layer on the support after the after-mentioned removing step to include at least the step of flattening the formed third color layer and the second color layer (the second color pattern) where the area for forming the above-mentioned third color pattern has been removed.

In the above-mentioned flattening treatment, it is more preferable that the second color layer laminated on the first color pattern is removed.

The details of the flattening treatment are as described above.

The width of the first color pattern is each independently preferably 0.6 to 1.7 μm, more preferably 0.8 to 1.5 μm from the viewpoint of further improving pattern formation limitation. In addition, the preferable range of the second color pattern is not described herein by reason of being limited by the size of the first color pattern and the size of the third color pattern.

The width of the third color pattern is preferably 0.6 to 1.7 μm, more preferably 0.8 to 1.5 μm from the viewpoint of further improving pattern formation limitation.

The specific thickness of the first to third color patterns is preferably 0.005 to 0.9 μm, more preferably 0.05 to 0.8 μm, far more preferably 0.1 to 0.7 μm from the viewpoint of further improving pattern formation limitation.

With regard to the color layer in the invention, the performance of the curing of the patterns only in a thermosetting component except a photosensitive component (such as a photopolymerizable monomer and a photopolymerization initiator) allows the ratio of a color component to be increased, and consequently allows a thinner film of a color filter to be realized.

A specific embodiment of forming the above-mentioned first and third color patterns by the above-mentioned 'photolithographic method' is not particularly limited, and a technique of known photolithography may be used while properly optimized.

For example, the after-mentioned color photocurable composition is first applied on a support directly or through another layer, and dried (preferably, further subject to prebake treatment) to form a color layer. The formed color layer is subjected to pattern exposure by a radiation, and the color layer subjected to pattern exposure is developed (preferably, further subjected to postbake treatment) to be capable of obtaining a color pattern.

Among the above-mentioned radiations, from the viewpoint of obtaining the effect by the invention more effectively, g ray, h ray and i ray are preferable, and i ray is more preferable among them.

Any developing solution may be used as developing solution used for the above-mentioned development as long as it dissolves an uncured portion. Specifically, a combination of various organic solvents and alkaline aqueous solution may be used.

A specific embodiment of forming a resist pattern by using a photoresist in the above-mentioned 'dry etching method' is not particularly limited, and a technique of known photolithography may be used while properly optimized.

For example, the after-mentioned positive or negative photosensitive resin composition (photoresist) is first applied on a color layer, and dried (preferably, further subjected to prebake treatment) to form a photoresist layer.

The formed photoresist layer is exposed by a radiation and developed (preferably, further subjected to postbake treatment) so as to form a resist pattern. Among the above-mentioned radiations, as exposure for the photoresist layer, in view of the object of the invention, g ray, h ray and i ray are preferable, and i ray is more preferable among them.

Any developing solution may be used as developing solution used for the above-mentioned development as long as it has no influence on the color layer including a coloring agent and dissolves an uncured portion (an exposed portion in the case of positive, an unexposed portion in the case of negative). Specifically, a combination of various organic solvents and alkaline aqueous solution may be used.

Among the above, a specific embodiment of the dry etching method in forming the first color pattern and the third color pattern, and the dry etching method in forming the second and the third color patterns by etch back treatment is not particularly limited, and an embodiment of known dry etching may be used while properly optimized. A preferable embodiment of the dry etching is described later.

A preferable embodiment of a method for forming the second and the third color patterns by polishing such as CMP is also described later.

<Removing step>

The removing step in the invention is a step that removes the area for forming a third color pattern in the above-mentioned first color pattern and/or the above-mentioned second color layer by dry etching.
The area for forming a third color pattern is preferably an area for forming a third color pixel. The area for forming a third color pixel may be specifically an optional area in accordance with an array of the third color pixel in a color filter to be produced.
For example, in the case of producing a color filter in a Bayer array as shown in Fig. 8, the area for forming a third color pattern may be an area of a check pattern as an area 18 for forming a green pixel in Fig. 4.
As shown in Fig. 19, in the case of producing a color fitter in an array such that the green pixels link to each other to make a green pattern 130 in stripe, the area for forming a third color pattern may be the same striped area as the green pattern 130 in stripe in Fig. 19.
A specific method for removing the above-mentioned area for forming a third color pattern by dry etching is appropriately a method for previously forming a resist pattern (that is, a resist pattern such that the area for forming a third color pattern is exposed) with the use of a photoresist by using a known photolithographic technique on the color layer to be dry-etched to perform dry etching treatment by using the resist pattern as an etching mask.
Here, the size of the area for forming a third color pattern (the length of a side of an aperture pattern in the case of the isolated aperture pattern, or the pattern width of an aperture pattern in the case of the striped aperture pattern) is preferably 0.6 to 1.7 μm, more preferably 0.8 to 1.5 μm.
A specific embodiment of the dry etching method in the removing step is not particularly limited, and an embodiment of known dry etching may be used while properly optimized. A preferable embodiment of the dry etching is described later.

<Stopper layer forming step>

The method for producing a color filter in the invention may include the stopper layer forming step (the step of forming a stopper layer on a first layer).

(The step of forming a stopper layer on a first layer)

In the invention, the first color pattern forming step may include the step that forms a first color layer on a support and the step that forms a stopper layer on the formed first color layer (the stopper layer forming step). In this case, it is more preferable that the first color pattern forming step further includes the step of forming a resist pattern on the formed stopper layer by using a photoresist to dry-etch the stopper layer and the first color layer by using the formed resist pattern as an etching mask.
The upper side surface of the formed first color pattern (the surface on the far side from the support among two surfaces of the color pattern, parallel to the support, and so forth) is covered with the stopper layer by making the first color pattern into the above-mentioned composition, so that a phenomenon such that the first color pattern is deteriorated in film thickness and damaged due to dry etching (etch back) and polishing treatment may be prevented more effectively. As a result, transmission spectral characteristics of the color pixel of a color filter are controlled more easily.
The above-mentioned stopper layer is preferably a layer lower in etching rate or polishing rate in polishing treatment such as CMP than the above-mentioned color layer or color pattern, and is preferably formed out of a transparent curable composition to visible light. Thus, a color filter may be produced without completely removing the stopper layer. Here, transparence to visible light signifies that the transmittance of visible light is 95% or more.
In the case that etching rate and polishing rate are equivalent or higher to the color layer, the stopper layer does not need to be left and may be produced so as to be removed by dry etching or polishing treatment.

<Heat treatment step>

It is preferable that the invention further includes the heat treatment step of heat-treating the color layer (including the color pattern and the color pixel) after removing the resist pattern at a temperature from 100°C to 220°C. Thus, moisture absorbed in the color layer (including the color pattern and the color pixel) may be vaporized, and a malfunction such as application defect in the color layer forming step occasionally performed later step may be restrained more effectively from occurring.

<Adhesion improving treatment>

In the method for producing a color filter in the invention, it is also preferable that adhesion improving treatment is performed on the support surface subjected to dry etching treatment, and a color layer is formed on the support

subjected to adhesion improving treatment to form a color pattern by exposing and developing the formed color layer.
The composition as described above allows adhesion between the color layer (the color pattern) and the support to be further improved, and allows peeling of the color layer (the color pattern) in developing to be restrained more effectively. For example, even though the support surface becomes hydrophilic by dry etching treatment (a contact angle between the support surface and water becomes less than 40°), overexposure for improving adhesion (increase in light exposure) does not need to be performed, and accurate pattern size and adhesion improvement may be compatible more effectively. Thus, it is particularly effective when the size of the color pattern is small.

In the method for producing a color filter in the invention, a specific embodiment of performing adhesion improving treatment is, for example, an embodiment including the step of performing adhesion improving treatment on the support surface after being dry-etched in the above-mentioned removing step to form a third color layer on the support subjected to adhesion improving treatment and then form a third color pattern by exposing and developing the formed third color layer.
This embodiment allows peeling of the third color pattern to be restrained more effectively.

The above-mentioned adhesion improving treatment is preferably hydrophobic treatment, more preferably hydrophobic treatment such that a contact angle between the support surface and water becomes 40° or more from the viewpoint of the effect of improving adhesion.
Also, the above-mentioned adhesion improving treatment is preferably treatment for applying an adhesion assistant and/or fluorinating treatment using plasma.

(The treatment for applying an adhesion assistant)

The treatment for applying an adhesion assistant may be performed by methods such as vapor treatment, application, inkjet offering, printing and vapor deposition, which are used in a general positive resist process.

In the case of application, various kinds of known methods such as slit coating, spin coating, cast coating, roll coating and spray coating may be adopted.

In the case of inkjet offering, a method for discharging by an inkjet method with the use of an inkjet head may be adopted. The inkjet head is appropriately a head of a charge control system of discharging ink by utilizing electrostatic attraction, a drop-on-demand system (a pressure pulse system) utilizing vibratory pressure of a piezo element, an acoustic inkjet system of discharging ink by utilizing radiation pressure while changing an electric signal into an acoustic beam to irradiate ink, a thermal inkjet (bubble jet (registered trademark)) system utilizing pressure caused by heating ink to form air bubbles, and the like.

In the case of printing, a screen printing method may be adopted.
In the case of vapor deposition, examples thereof include atomizing by a spray, vapor deposition by vaporization, and dipping. Among them, vapor deposition by vaporization is preferable, in which case the treatment is preferably performed under reduced pressure for approximately 30 to 600 seconds.

In the case of application and inkjet offering, a solution prepared by using an adhesion assistant is used. A solution prepared by mixing and dissolving a desired adhesion assistant in a solvent such as cyclohexanone may be used for this solution.

After applying an adhesion assistant, drying is preferably performed by using a hot plate and an oven at a temperature of 50 to 300°C for approximately 30 to 600 seconds.

Silicon nitride and silicon oxide may be used as the above-mentioned adhesion assistant in view of curable portion (image) adhesion properties and uncured portion developability acting with the after-mentioned color layer (particularly, an organic silane compound). Among them, a compound represented by the following formula (A) is preferable in view of forming a color pattern excellent in adhesion properties to the support surface without deteriorating development residue of an uncured portion (an unexposed portion). However, the invention is not limited thereto.

Formula (A)

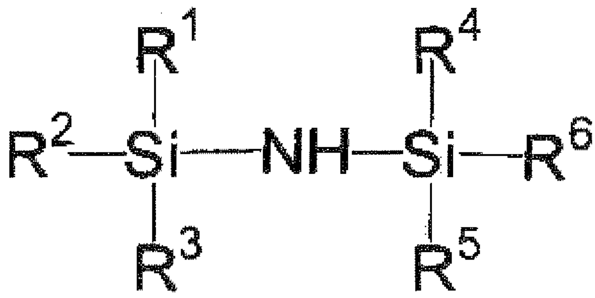

In the above-mentioned formula (A), $R^1$ to $R^6$ each independently represent a hydrocarbon group with a carbon number from 1 to 4 and may have a ring system and/or an unsaturated bond in structure. Examples of the hydrocarbon group with a carbon number from 1 to 4 include a methyl group, an ethyl group, a propyl group and a butyl group. Among them, the case where all of the $R^1$ to $R^6$ are methyl groups is preferable.

Specific examples of a compound represented by the above-mentioned formula (A) are listed. However, the invention is not limited thereto.

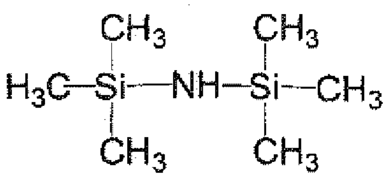

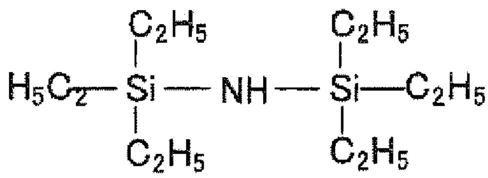

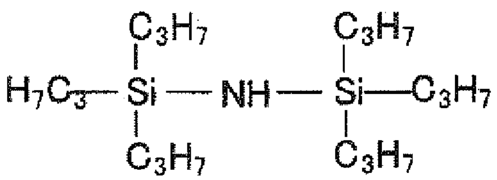

With regard to the amount of the adhesion assistant on a support, the contact angle of water on the support with the adhesion assistant treated is preferably 50° or more, more preferably 60° or more. The above-mentioned range allows adhesion properties of a color pattern composing a color filter to be effectively improved while restraining development residue of the after-mentioned curable layer in an unexposed area to be essentially removed by developing.

(The fluorinating treatment using plasma)

The fluorinating treatment using plasma is preferably an embodiment of ion-irradiating fluorine-based gas (fluorocarbon gas such as $CF_4$) while making into plasma. In particular, an embodiment of plasma-treating the surface while making fluorocarbon gas containing no oxygen gas into plasma is more preferable from the viewpoint of being hydrophobic.

The fluorinating treatment using plasma may be specifically used by the same method as another dry etching treatment in the invention.

Known gas may be used as the fluorine-based gas in the invention, which is preferably gas represented by the following formula (B).

$C_nH_mF_1$ Formula (B)

[In the formula (B), n represents 1 to 6, m represents 0 to 13 and 1 represents 1 to 14.]

The fluorine-based gas represented by the above-mentioned formula (B) is preferably used by mixing while optionally selecting from the group consisting of $CF_4$, $C_2F_6$, $C_3F_8$, $C_2F_4$, $C_4F_8$, $C_4F_6$, $C_5F_8$ and $CHF_3$. Among them, it

is more preferable to optionally select from the group consisting of $CF_4$, $C_2F_6$, $C_4F_8$ and $CHF_3$, it is far more preferable to optionally select from the group consisting of $CF_4$ and $C_2F_6$, and $CF_4$ is particularly preferable from the viewpoint of general-purpose properties.

The fluorine-based gas in the invention may be used by selecting one kind of gas from among the above-mentioned group, and may contain two kinds or more as mixed gas.

The conditions of the plasma treatment are preferably an RF power of 300 W or more and 5 seconds or less.

In the above, each of the steps composing the method for producing a color filter in the invention is described, and these steps may be combined in any manner. For example, in the formation of the first to third color patterns, any of a photolithographic method, a dry etching method and a flattening method each independently may be used or the methods may be used in combination.

A step except the above-mentioned steps may be included unless the effect of the invention is hindered.

Specific exemplary embodiments (a first exemplary embodiment and a second exemplary embodiment) of the method for producing a color filter in the invention are described below, and the invention is not limited to these exemplary embodiments.

Either a photosensitive composition or a thermosetting composition may be used for a color layer except pattern formation by a photolithographic method.

<First exemplary embodiment>

The first exemplary embodiment is an exemplary embodiment of forming all of the first to the third color patterns by a photolithographic method. The first exemplary embodiment is hereinafter described while referring to Figs. 1 to 8. In Figs. 1 to 8, A is a plan view and B is an A-A' line cross-sectional view of A. In Figs. 4 to 8, C is a B-B' line cross-sectional view of A.

(The first color pattern forming step)

First, as shown in Fig. 1, for example, a blue pattern material is applied on a support 10 to form a blue color layer 12 as a first color layer into a predetermined film thickness. Thereafter, pattern exposure, development and postbake treatment are performed to form a blue pattern 14, which is a striped pattern as shown in Fig. 2, as a first color pattern. Then, in the case that a color filter array is designed as an assembly of square patterns, it is desirable that a pattern width of the blue pattern 14: an interval of the blue pattern 14 (that is, a width of an area with no blue pattern formed) is formed into a ratio of 1:1, but yet is not so depending on a device design.

(The second color layer forming step)

Next, as shown in Fig. 3, for example, a red filter material is applied to the surface on the side, on which the blue pattern 14 is formed, of the support with the blue pattern 14 formed to form a red color layer 16 as a second color layer into a predetermined film thickness, and thereafter perform postbake treatment. As shown in Fig. 3, the red color layer 16 is embedded between the blue patterns 14 in stripe, and formed so as to cover the blue patterns 14 in stripe.

The color of the first color pattern and the color of the second color layer are not particularly limited.

For example, an exemplary embodiment of forming the first color pattern into red and forming the second color layer into blue may be performed as well as the above-mentioned exemplary embodiment of forming the first color pattern into blue and forming the second color layer into red.

In the case of forming a color filter of coloration as shown in Fig. 19, an exemplary embodiment of forming the first color pattern into green and forming the second color layer into blue or red may be also performed.

However, the exemplary embodiment of forming the first color pattern into blue and forming the second color layer into red, or the exemplary embodiment of forming the first color pattern into red and forming the second color layer into blue are preferable from the viewpoint of increasing the step of forming a striped pattern and obtaining the effect of the invention more effectively.

(The removing step)

Next, as shown in Fig. 4, a photoresist is applied to the surface on the side, on which the blue pattern 14 and the red color layer 16 has been formed, of the support and an area for forming a third color pattern, such as an area 18 for forming a green pixel, in the first color pattern and/or the second color layer is removed by exposure and development treatment, and thereafter form a resist pattern 20 by performing postbake treatment.

Next, as shown in Fig. 5, the area 18 for forming a green pixel in the blue pattern 14 and the red color layer 16 is removed by dry etching to form a blue pixel 22 as well as a red pixel 24 and a red pattern 25 as the second color pattern, and

thereafter remove the resist pattern 20. Then, as shown in Fig. 5B, the red pattern 25 is laminated on the blue pixel 22.

(The third color pattern forming step)

Next, as shown in Fig. 6, a green filter material is applied to the surface on the side, on which the blue pixel 22 and the like have been formed, of the support to form a green color layer 26 as a third color layer.
The area for forming a green pixel in the formed green color layer 26 is exposed, developed and subjected to postbake treatment to form a green pattern. 28 (that is, a green pixel 30) as a third color pattern as shown in Fig. 7.

(The flattening treatment step)

Next, the flattening treatment is performed for removing the red pattern 25 on the blue pixel 22. Here, the treatment is performed by CMP treatment on the above-mentioned polishing conditions until the blue pixel 22 is exposed. An endpoint of the polishing may be detected by the exposure of the blue pixel 22. In addition, overpolishing may be performed by approximately 20%. After finishing polishing, cleaning treatment of the support is performed with pure water to thereafter perform dehydration bake treatment.
Then, the flattening treatment may be also performed by the etch back step instead of the CMP step, and the flattening treatment may be also performed by using the CMP step and the etch back step together.
A color filter array having the blue pixel 22, the red pixel 24 and the green pixel 30 as shown in Fig. 8 is formed by the above steps.

<Second exemplary embodiment

The above-mentioned first and third color patterns may be formed by not merely a photolithographic method but also dry etching (including both the case of forming by the above-mentioned 'dry etching method' and the case of forming by the above-mentioned 'etch back treatment', and so forth).
The second exemplary embodiment of forming all of the first to the third color patterns by dry etching is hereinafter described while referring to Figs. 9 to 18.
In Fig. 9 to 18. A is a plan view and B is an A-A' line cross-sectional view of A. In Figs. 14 to 18, C is a B-B' line cross-sectional view of A.
An exemplary embodiment of having a stopper layer is herein described.

(The first color pattern forming step)

As shown in Fig. 9, for example, a red filter material is applied on a support 40 to form a red color layer 42 as a first color layer, and a stopper layer 44 is further formed on the formed red color layer 42 and subjected to baking treatment.
Fig. 9A shows a plan view when the stopper layer 44 is a transparent film, so that not a white background showing the stopper layer 44 as the upper layer but a dotted pattern showing the red color layer 42 as the lower layer is drawn (and so forth in later Figs.).
Thereafter, as shown in Fig. 10, a photoresist is applied on the stopper layer 44 to form an applied film, which is subjected to pattern exposure, development and postbake treatment to form a resist pattern 46 in an area for forming a red pattern.
Next, dry etching is performed for the stopper layer 44 and the red color layer 42 by using the resist pattern 46 as an etching mask to forum a red pattern 48 as a first color pattern as shown in Fig. 11. Thereafter, the resist pattern 46 is removed as shown in Fig. 12.
In this second exemplary embodiment, as shown in Fig. 12, the red pattern 48 as a first color pattern is formed in a stripe shaped pattern having the stopper layer 44 in the upper layer.

(The second color layer forming step)

Next, as shown in Fig. 13, for example, a blue filter material is applied to the surface on the side, on which the stopper layer 44 and the red pattern 48 are formed, of the support to form a blue color layer 50 as a second color layer into a predetermined film thickness. Thereafter, postbake treatment is performed.

(The removing step)

Next, as shown in Fig. 14, a photoresist is applied to the surface on the side, on which the red pattern 48, the stopper layer 44 and the blue color layer 50 are formed, of the support to remove an area for forming a third color layer,

such as an area 52 for forming a green pixel, by pattern exposure and development treatment, and thereafter form a resist pattern 54 by performing postbake treatment.

Next, the area 52 for forming a green pixel in the stopper layer 44, the red pattern 48 and the blue color layer 50 is removed by dry etching by using the resist pattern 54 as an etching mask, to form a red pixel 56 as well as a blue pixel 58 serving as the second color pattern and a blue pattern 59 as shown in Fig. 15. Thereafter, the resist pattern 54 is removed as shown in Fig. 16.
Then, as shown in Fig. 16B, the stopper layer 44 and the blue pattern 59 are laminated on the red pixel 56.

(The third color pattern forming step)

Next, as shown in Fig. 17, a green filter material is applied to the surface on the side, on which the red pixel 56 and the like is formed, of the support 40, to form a green color layer 60 serving as a third color layer. Thereafter, postbake treatment is performed.
Thereafter, etch back treatment is performed while sharpening until the stopper layer 44 is exposed, to form a green pattern 62 (that is, a green pixel 64) serving as a third color pattern. The state after the etch back is shown in Fig. 18.

After forming the green color layer 60 in the above-mentioned Fig. 17, the CMP treatment may be performed instead of performing the above-mentioned etch back treatment, and the etch back treatment and the CMP treatment may be used together.

The remaining film of the stopper layer varies with the etching rate and the polishing rate. In the case that the rate is slower than the color layer, the remaining film may be such as to remain on the first color pattern after finishing etching or polishing.

A color filter array having the red pixel 56, the blue pixel 58 and the green pixel 64 as shown in Fig. 18 is formed by the above steps.

In the above, a method for producing a color filter array in a Bayer array, such that the third color pattern has been arrayed in a check pattern was described as the first exemplary embodiment and the second exemplary embodiment. However, with regard to the color filter and the producing method therefor of the invention, the array of color pixels is not limited to the array in the first exemplary embodiment and the second exemplary embodiment.

For example, as shown in Fig. 19, an array such that a green pattern 130 is a striped pattern may be produced. Here, Fig. 19 is a view showing a color filter array having the green pattern 130 such that a red pixel 124, a blue pixel 122 and a green pixel link to each other. In this color filter array, a green pixel unit (square) of a solid-state imaging device links to each other to form the green pattern 130 in a stripe pattern as shown in Fig. 19.
The color filter array shown in Fig. 19 may be produced in such a manner that the first color pattern is formed in red or blue in stripe, the second color layer is formed in blue or red, and a striped area in a direction orthogonal to the first color pattern is removed as the area for forming the third color pattern by dry etching, to form the third color pattern in a stripe pattern in green color in the above-mentioned removed area.
In addition, the color filter array shown in Fig. 19 may be also produced in such a manner that the first color pattern is formed in green in stripe, the second color layer is formed in blue or red, and plural square open areas (the open areas are selected from portions except portions above the above-mentioned first color pattern) is removed as the area for forming the third color pattern by dry etching, to form the third color pattern in a square isolated pattern in red color or blue color in the above-mentioned removed area. However, the former method is more preferable to the latter method as a method for producing the color filter shown in Fig. 19 in view of increasing the step of forming a striped pattern and obtaining the effect of the invention more effectively.

The color filter and the producing method therefor of the invention may be applied to any array such as an array such that the third color pattern is a striped pattern in a direction parallel to the first color pattern, and an array such that the third color pattern is arranged in a direction inclined to the first color pattern.
In the method for producing the color filter of the invention, the method for forming the first to the third color patterns is not limited to the above-mentioned first and second exemplary embodiments, and any combination of a photolithographic method, a dry etching method and a flattening method may be applied. That is to say, in the case of forming a color filter having color pixels in three colors of R (red), G (green) and B (blue), any method of a photolithographic method, a dry etching method and a flattening method may be applied to any pixel, and a combination of plural methods may be applied.

<Dry etching>

In the method for producing the color filter of the invention, dry etching is performed in the removing step. Also, when the color pattern is formed by the above-mentioned 'dry etching method' and 'etch back treatment', dry etching is performed.

The embodiment of these dry etchings is not particularly limited and the dry etchings may be performed by a known embodiment.

Typical examples of the dry etchings is known in the methods described in JP-A Nos. 59-126506, 59-46628, 58-9108, 58-2809, 57-148706, and 61-41102.

(Preferable embodiment of dry etching)

The dry etching in the invention is preferably performed according to the following embodiment from the viewpoint of forming a pattern cross section closer to that of a rectangle and further decreasing damage to a support.
That is to say, an embodiment is preferable which includes a first stage etching of etching up to an area (depth) with no support exposed by using mixed gas of fluorine-based gas and oxygen gas ($O_2$), a second stage etching of preferably etching up to the vicinity of an area (depth) with the support exposed by using mixed gas of nitrogen gas ($N_2$) and oxygen gas ($O_2$) after the above-mentioned first stage etching, and an over-etching performed after the support has been exposed.
A specific manner of etching as well as the first stage etching, the second stage etching and the over-etching in the above-mentioned preferable embodiment of dry etching are hereinafter described.

*Calculation of etching conditions*

The dry etching in the above-mentioned preferable embodiment may be performed while previously obtaining the constitution of the etching conditions by the following manner.

1. The etching rate (nm/min) in the first stage etching and the etching rate (nm/min) in the second stage etching are each calculated.
2. The time for etching a predetermined thickness in the first stage etching and the time for etching a predetermined thickness in the second stage etching are each calculated.
3. The first stage etching is performed in accordance with the etching time calculated in the above-mentioned '2.'.
4. The second stage etching is performed in accordance with the etching time calculated in the above-mentioned '2.'. Alternatively, the etching time is determined by endpoint detection, and the second stage etching may be performed in accordance with the determined etching time.
5. The over-etching time is calculated with respect to the total time of the above-mentioned '3.' and '4.', and the over-etching is performed in accordance with obtained time.

*First stage etching step*

The mixed gas used in the above-mentioned first stage etching step contains fluorine-based gas and oxygen gas ($O_2$) from the viewpoint of processing an organic material serving as the etched film into rectangle shape. The first stage etching step may avoid damage to a support by adopting an embodiment of etching up to an area with no support exposed.

*Second stage etching step, over-etching step*

After the etching is performed up to an area with no support exposed by the above-mentioned mixed gas of fluorine-based gas and oxygen gas in the above-mentioned first stage etching step, etching treatment in the second stage etching step and etching treatment in the over-etching step may be performed by using the mixed gas of nitrogen gas and oxygen gas from the viewpoint of avoiding damage to a support.

*Preferable ratio of etching amount*

The ratio between the etching amount in the first stage etching step and the etching amount in the second stage etching step is preferably determined without deteriorating rectangularity by etching treatment in the first stage etching step.
The ratio of the etching amount in the second stage etching step in the total etching amount (the total sum of the etching amount in the first stage etching step and the etching amount in the second stage etching step) is preferably a range of more than 0% and 50% or less, more preferably 10 to 20%. Here, the etching amount signifies the depth in which the etched film is etched.

<Polishing treatment>

An embodiment of performing polishing treatment such as CMP treatment as flattening treatment is also appropriate in the method for producing the color filter of the invention.

Aqueous solution with a pH of 9 to 11 containing $SiO_2$ abrasive grains with a particle diameter of 10 to 100 nm by 0.5 to 20% by mass is preferably used as slurry used for the polishing treatment. A soft type such as continuous expanded urethane may be preferably used as a polishing pad.
The polishing may be performed by using the above-mentioned slurry and polishing pad on the conditions of slurry flow rate: 100 to 250 ml/min, wafer pressure: 0.2 to 5.0 psi, and retainer ring pressure: 1.0 to 2.5 psi.
The polishing treatment may be completed by performing precision cleaning and dehydration bake (preferably at a temperature of 100 to 200°C for 1 to 5 minutes) after finishing the polishing.

<Support>

A support in the invention is not particularly limited if used for a color filter; examples thereof include soda glass, borosilicate glass, quartz glass and these with a transparent conductive film attached, used for a liquid crystal display element, and a photoelectric conversion element substrate such as a silicon substrate, an oxide film and silicon nitride, used for a solid-state imaging device. An interlayer may be provided between these supports and color patterns unless the invention is deteriorated.

<Color pattern>

The first to the third color patterns (the first to the third color layers) in the invention are preferably formed by a color curable composition containing a coloring agent. Examples of the above-mentioned color curable composition include a color photocurable composition and a non-photosensitive color thermosetting composition.
The above-mentioned first to third color patterns may compose at least one kind of color pixel of the color filter in the invention.
The above-mentioned first to third color patterns may adopt a color photocurable composition in the case of being formed by a photolithographic method, and adopt a non-photosensitive color thermosetting composition containing no photocurable components in the case of being formed by dry etching. Thus, in the case of forming by dry etching, the concentration of a coloring agent in the composition may be increased and spectral characteristics of the color filter with a thinner film may be obtained.

(Color photocurable composition)

The above-mentioned color photocurable composition contains at least a coloring agent and a photocurable component. 'Photocurable component' therein is a photocurable composition ordinarily used for a photolithographic method, for which a composition containing at least binder resin (such as alkali-soluble resin), a photosensitive polymerization component (such as a photopolymerizable monomer) and a photopolymerization initiator may be used.
For example, the items described in the paragraph number of 0017 to 0064 in JP-A No. 2005-326453 may be directly applied to the color photocurable composition.
An organic silane compound is preferably contained in the color photocurable composition from the viewpoint of adhesion properties to the support.
In particular, when dry etching treatment is performed on the support surface before the color photocurable composition is applied on the support, it is more preferable that an organic silane compound is contained in the color photocurable composition. Such a constitution allows adhesion between the color layer (the color pattern) and the support to be further improved, and allows peeling of the color layer (the color pattern) in developing to be restrained more effectively. Thus, for example, even though the support surface becomes hydrophilic by dry etching treatment (a contact angle between the support surface and water becomes less than 40°), overexposure for improving adhesion (increase in light exposure) does not need to be performed, and accurate pattern size and adhesion improvement may be compatible more effectively. Thus, it is particularly effective when the size of the color pattern is small.
The preferable content of an organic silane compound in the whole solid content of the color photocurable composition varies whether the above-mentioned adhesion improvement treatment is performed or not for the support before the color photocurable composition is applied on the support.
When the color photocurable composition is applied while performing the adhesion improvement treatment for the support, the content of an organic silane compound is preferably 0.05 to 1.2% by mass, more preferably 0.1 to 1.2% by mass, particularly preferably 0.2 to 1.1% by mass with respect to the whole solid content of the color photocurable composition.
On the other hand, when the color photocurable composition is applied without performing the adhesion improvement treatment for the support, the content of an organic silane compound is preferably 0.3 to 1.2% by mass, more preferably 0.4 to 1.2% by mass, particularly preferably 0.5 to 1.1% by mass with respect to the whole solid content of the color photocurable composition.

The content of a specific organic silane compound in the above-mentioned range allows adhesion between the support surface and the color pattern to be further improved without deteriorating storage stability of the color photocurable composition and development residue in an area to be removed by development.

In the method for producing the color filter of the invention, a specific embodiment of containing an organic silane compound in the color photocurable composition is more preferably the following embodiment.

That is to say, the embodiment is an embodiment including the step of forming the third color layer on the support after dry etching treatment in the above-mentioned removing step, by using a color curable composition having an organic silane compound, and then exposing and developing the formed color layer to form the third color pattern. The above-mentioned adhesion improvement treatment may be performed on the support surface immediately before forming the third color layer.

This embodiment allows peeling of the third color pattern to be restrained more effectively.

Examples the organic silane compound include a compound having Si in a molecule.

Above all, the compound is preferably an organic silane compound represented by the formula (I) shown below (occasionally referred to as 'specified organic silane compound.' hereinafter).

*Organic silane compound represented by the formula (I)*

The color photocurable composition in the invention preferably contains at least one kind of the organic silane compounds represented by the following formula (I) (specified organic silane compounds). The containing of these specified organic silane compounds allows adhesion to the support to be further improved. Moreover, when the color photocurable composition is in an unexposed state, the development is favorable and the development residue may be restrained.

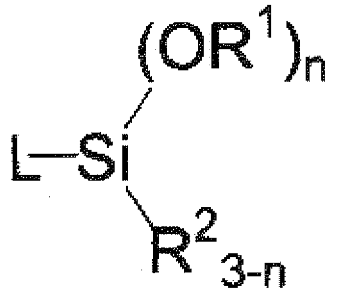

(I)

In the above-mentioned formula (I), L represents a monovalent organic group, and $R^1$ and $R^2$ each independently represent a hydrocarbon group. n represents an integer from 1 to 3.

Examples of the monovalent organic group represented by L include an alkyl group, an alkenyl group, an aryl group, an alkoxy group, an amino group, each of which may be optionally substituted and has 1 or more carbon atoms or a group with these combined. Above all, an alkyl group which may be optionally substituted having 1 to 20 carbon atoms is preferable.

Examples of the hydrocarbon group represented by $R^1$ and $R^2$ include a straight-chain, branching or cyclic alkyl group (such as a methyl group, an ethyl group, a propyl group, an isopropyl group, a butyl group, an isobutyl group, a pentyl group, a hexyl group, a cyclohexyl group and a phenyl group). Above all, $R^1$ and $R^2$ preferably represent a straight-chain, branching or cyclic alkyl group having 1 to 12 carbon atoms, more preferably a straight-chain alkyl group having 1 to 6 carbon atoms, particularly preferably a methyl group and an ethyl group.

n represents an integer from 1 to 3, preferably 2 and 3 from the viewpoint of stability and adhesion.

The organic silane compound in the invention is preferably a compound having at least one hydrophilic part in a molecule, more preferably a compound having plural hydrophilic parts. In the case that plural hydrophilic parts exist in a molecule, the hydrophilic parts may be the same or different from each other.

Among the organic silane compounds represented by the above-mentioned formula (I), an organic silane compound represented by the following formula (II) is preferable in view of curability and removability when a portion except the curable portion after being cured is removed by developing. That is, the compound is an organic silane compound having a monovalent organic group including a hydrophilic part.

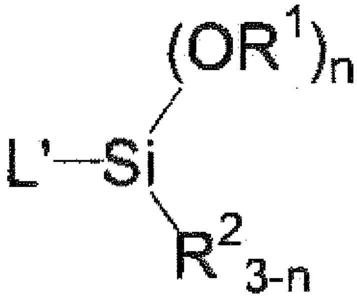

(II)

In the above-mentioned formula (II), L' represents a monovalent organic group including a hydrophilic part. $R^1$ and $R^2$ each independently represent a hydrocarbon group and have the same definitions as $R^1$ and $R^2$ in the formula (I), and the details and preferable embodiments thereof of the hydrocarbon groups represented by $R^1$ and $R^2$ are the same as the case of the formula (I).

n represents an integer from 1 to 3, preferably 2 and 3 from the viewpoint of stability and adhesion.

'A monovalent organic group including a hydrophilic part' represented by L' is hereinafter described.

'A hydrophilic part' included in a monovalent organic group L' represents a polar atomic group with a high affinity for a high polar substance typified by water, and includes atoms such as oxygen, nitrogen, sulfur and phosphorus. Examples of such a hydrophilic part include a part capable of dipole-dipole interaction, dipole-ion interaction, ionic bond and hydrogen bond with a high polar substance typified by water.

Examples of the hydrophilic part include a polar group and a dissociable group including atoms such as oxygen, nitrogen and sulfur, hydrogen bond donor, hydrogen bond acceptor, and a part having plural lone-pair electrons to be capable of offering a hydrophilic field by an assembly thereof. Specific examples thereof include hydrophilic groups such as a hydroxy group, an amino group, a carbonyl group, a thiocarbonyl group, a mercapto group, a carbamoyl group, a carbamoyloxy group and a carbamoylamino group; a sulfonamide part, a urethane part, a thiourethane part, an amide part, an ester part, a thioether part, a urea part, a thiourea part, an oxycarbonyloxy part, an ammonium group, a secondary amine part, a tertiary amine part, a polyethyleneoxy part represented by $-(CH_2CH_2O)_a-$ (provided that, a represents an integer of 2 or more), an oxycarbonyloxy part, and a partial structure represented by the following structural formulae (monovalent to trivalent hydrophilic parts).

Monovalent hydrophilic part

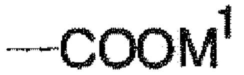

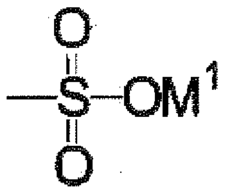

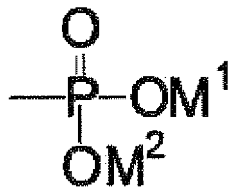

Divalent hydrophilic part

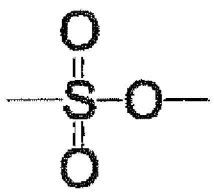

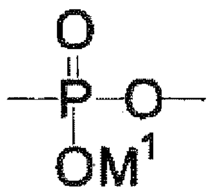

Trivalent hydrophilic part

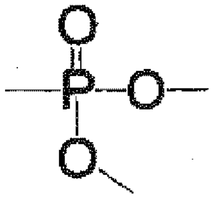

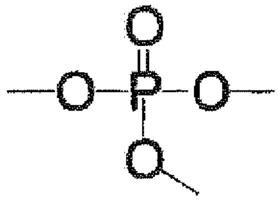

In the above-mentioned structural formulae, $M^1$ and $M^2$ each independently represent a hydrogen atom and a monovalent metal atom (such as lithium, sodium and potassium).

Among such hydrophilic parts, a structure such that Michael addition reaction is not caused with the ethylenic double bond of a compound having an ethylenic unsaturated double bond (such as the above-mentioned photopolymerizable monomer) is more preferable from the viewpoint of temporal stability of the color photocurable composition. The following are preferable from such a viewpoint: a hydroxy group, a carbonyl group, a thiocarbonyl group, a carbamoyl group, a carbamoyloxy group, a carbamoylamino group, a urethane part, a thiourethane part, an amide part, an ester part, a thioether part, a urea part, a thiourea part, an oxycarbonyloxy part, an ammonium group, a tertiary amine part, a polyethyleneoxy part represented by $-(CH_2CH_2O)_a-$ (provided that, a represents an integer of 2 or more), an oxycarbonyloxy part, and a partial structure represented by the above-mentioned structural formulae (monovalent to trivalent hydrophilic parts).

A hydrolytic reaction of $-Si(OR^1)_nR^2{}_{3-n}$ as a partial structure of the above-mentioned formula (II) occasionally becomes a factor for thickening of the curable composition with time. The following are preferable among the hydrophilic parts from the viewpoint of inducing such a hydrolytic reaction with difficulty: a hydroxy group, a carbonyl group, a thiocarbonyl group, a urethane part, a thiourethane part, an amide part, an ester part, a thioether part, a carbamoyl group, a carbamoyloxy group, a carbamoylamino group, a urea part, a thiourea part, a tertiary amine part, and a polyethyleneoxy part; a hydroxy group, a urethane part, a thiourethane part, an amide part, a sulfonamide part, an ester part, a urea part, a thiourea part, a tertiary amine part, and a polyethyleneoxy part are more preferable; a hydroxy group, a urethane part, a thiourethane part, a urea part, a tertiary amine part, and a polyethyleneoxy part represented by $-(CH_2CH_2O)_a-$ (provided that, a represents an integer of 2 or more) are most preferable.

Among the above-mentioned specified organic silane compounds, a compound represented by the following formula (III) or formula (IV) is more preferable.

*Organic silane compound represented by the formula (III)*

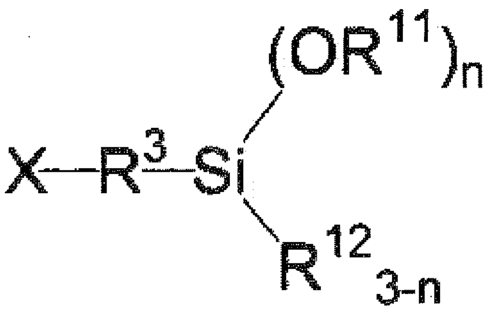

(III)

In the above-mentioned formula (III), $R^{11}$ and $R^{12}$ each independently represent a hydrocarbon group having 1 to 6 carbon atoms. Examples of the hydrocarbon group having 1 to 6 carbon atoms represented by $R^{11}$ and $R^{12}$ include a straight-chain, branched-chain or cyclic alkyl group having 1 to 6 carbon atoms (such as a methyl group, an ethyl group, a propyl group, an isopropyl group, a butyl group, an isobutyl group, a pentyl group, a hexyl group, a cyclohexyl group and a phenyl group). Above all, preferably, $R^{11}$ and $R^{12}$ each independently represent a methyl group or an ethyl group.

$R^3$ represents a divalent hydrocarbon group having 1 to 12 carbon atoms and the hydrocarbon group may be unsubstituted or substituted. The hydrocarbon structure of the hydrocarbon group may have a cyclic structure and/or an unsaturated bond therein. The hydrocarbon structure may have a monovalent hydrophilic part therein. The hydrophilic

part herein signifies the monovalent hydrophilic part as described in the above-mentioned L', and has the same preferable examples as described therein.
The details of the divalent hydrocarbon group represented by $R^3$ will be described later.

X represents a monovalent hydrophilic part. The hydrophilic part herein signifies the monovalent hydrophilic part as described in the above-mentioned L', and has the same preferable examples as described therein.
n represents an integer from 1 to 3, preferably 2 and 3 from the viewpoint of stability and adhesion.

*Organic silane compound represented by the formula (IV)*

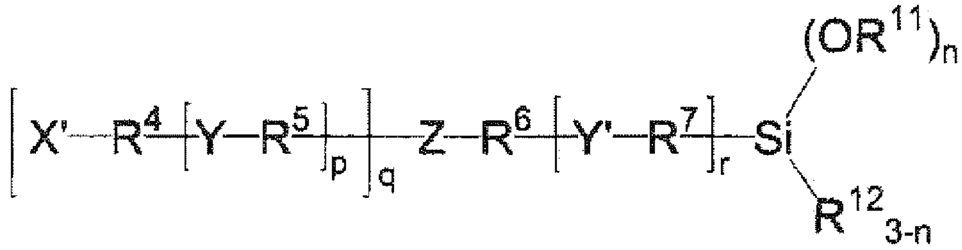

(IV)

In the above-mentioned formula (IV), $R^{11}$ and $R^{12}$ each independently represent a hydrocarbon group having 1 to 6 carbon atoms. Examples of the hydrocarbon group having I to 6 carbon atoms represented by $R^{11}$ and $R^{12}$ include a straight-chain, branched-chain or cyclic alkyl group having 1 to 6 carbon atoms (such as a methyl group, an ethyl group, a propyl group, an isopropyl group, a butyl group, an isobutyl group, a pentyl group, a hexyl group, a cyclohexyl group and a phenyl group). Above all, preferably, $R^{11}$ and $R^{12}$ each independently represent a methyl group or an ethyl group.

$R^4$, $R^5$, $R^6$ and $R^7$ each independently represent a single bond or a hydrocarbon chain (a divalent hydrocarbon group) having 1 to 12 carbon atoms, which may be unsubstituted or substituted. In the case that $R^4$, $R^5$, $R^6$ and $R^7$ represent a hydrocarbon chain (a divalent hydrocarbon group), the hydrocarbon structure may have a cyclic structure and/or an unsaturated bond therein. The hydrocarbon chain (the divalent hydrocarbon group) may be such as to have a monovalent hydrophilic part as a substituent.
The details of the divalent hydrocarbon group represented by $R^4$, $R^5$, $R^6$ and $R^7$ will be described later.

X' represents a hydrogen atom or a monovalent substituent and the monovalent substituent may include a hydrophilic part. The hydrophilic part herein signifies the monovalent hydrophilic part as described in the above-mentioned L', and has the same preferable examples as described therein.

Y and Y' each independently represent a divalent hydrophilic part, Z represents a divalent or trivalent hydrophilic part in accordance with the value of q, and q represents 1 or 2. That is, when q represents 1, Z represents a divalent hydrophilic part; when q represents 2, Z represents a trivalent hydrophilic part. Examples of the divalent or trivalent hydrophilic part include the same as exemplified as the divalent or trivalent hydrophilic part among the hydrophilic parts described in the above-mentioned formula (I) or formula (II).
p represents an integer from 0 to 20, r represents an integer from 0 to 3, and n represents an integer from 1 to 3.

When $R^3$ in the above-mentioned formula (III) or $R^4$, $R^5$, $R^6$ and $R^7$ in the above-mentioned formula (IV) represent a divalent hydrocarbon group, an alkyl group including a straight-chain, branched-chain or cyclic structure and an aromatic ring group are preferable and these may have a substituent.
Examples of the substituent capable of being introduced into this divalent hydrocarbon group include an aliphatic group, an aromatic group, a heterocyclic group, a halogen atom, a cyano group, a nitro group, an aliphatic oxy group, an aromatic oxy group, a heterocyclic oxy group and a hydrophilic group; among them, an aliphatic group having 1 to 12 carbon atoms, an aromatic group, a heterocyclic group, a chlorine atom, a cyano group and a hydrophilic group are preferable.
Preferable examples of the aliphatic group having 1 to 12 carbon atoms include a methyl group, an ethyl group, a propyl group, an isopropyl group, a butyl group, an isobutyl group, a pentyl group, a hexyl group, a cyclohexyl group and an octyl group; among them, a methyl group, an ethyl group and a propyl group are preferable.
Examples of the aromatic group include a phenyl group, a naphtyl group and an anthracene group; a phenyl group is preferable.
Examples of the heterocyclic group include a morpholino group, a tetrahydrofurfuryl group, a pyrrolyl group, a furyl group, a thiophenyl group, a benzopyrrolyl group, a benzofuryl group, a benzothiophenyl group, a pyrazolyl group, an isoxazolyl group, an isothiazolyl group, an indazolyl group, a benzoisoxazolyl group, a benzoisothiazolyl group, an imidazolyl group, an oxazolyl group, a thiazolyl group, a benzoimidazolyl group, a benzooxazolyl group, a benzothiazolyl group, a pyridyl group, a quinolinyl group, an isoquinolinyl group, a pyridazinyl group, a pyrimidinyl group, a pyrazinyl group, a cinnolinyl group, a phthalazinyl group, a quinazolinyl group, a quinoxalinyl group, an acridinyl group, a phenanthridinyl group, a

phthalazinyl group, a carbazolyl group, a carborinyl group, a purinyl group, a triazolyl group, an oxadiazolyl group and a thiadiazolyl group and the like; a morpholino group, a tetrahydrofurfuryl group and a pyridyl group are preferable. Examples of the hydrophilic group include a hydroxy group, an amino group, a carbonyl group, a thiocarbonyl group, a mercapto group, a carbamoyl group, a carbamoyloxy group and a carbamoylamino group; a hydroxy group, a carbonyl group and a amino group are preferable.

Examples of the optional 'monovalent hydrophilic part' when $R^3$ in the above-mentioned formula (III) or $R^4$, $R^5$, $R^6$ and $R^7$ in the above-mentioned formula (IV) represent a divalent hydrocarbon group include a hydroxy group, an amino group, a mercapto group, an ammonium group, a carbamoyl group, a carbamoyloxy group, a carbamoylamino group, and a partial structure part represented by the following structural formulae ($M^1$ and $M^2$ represent as described above).

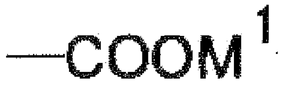
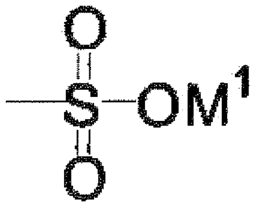
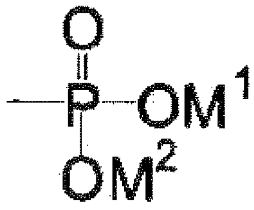

Among the above, 'a divalent hydrocarbon group' represented by $R^3$ in the above-mentioned formula (III) is preferably a methylene chain having 1 to 5 carbon atoms, or a methylene chain optionally having a substituent and optionally including an oxygen atom in the chain (more preferably a methylene chain with a carbon number of 3). 'A divalent hydrocarbon group' represented by $R^4$, $R^5$, $R^6$ and $R^7$ in the above-mentioned formula (IV) is preferably a methylene chain having 1 to 5 carbon atoms, or a methylene chain optionally having a substituent and optionally including an oxygen atom in the chain (more preferably a methylene chain having 3 carbon atoms).

Preferable examples of the monovalent hydrophilic part in X in the above-mentioned formula (III) or X' in the above-mentioned formula (IV) include a hydroxy group, an amino group, a mercapto group, an ammonium group, a carbamoyl group, a carbamoyloxy group, a carbamoylamino group, and a partial structure part represented by the following structural formulae ($M^1$ and $M^2$ represent as described above).

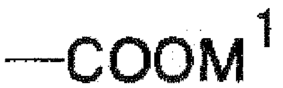
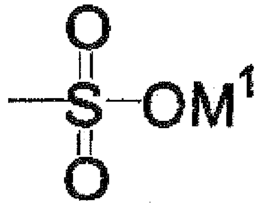
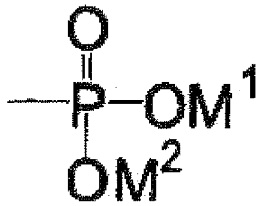

When $Y^1$, $Y^2$ and Z in the above-mentioned formula (IV) represent a divalent hydrophilic part, preferable examples thereof include a carbonyl group, a thiocarbonyl group, a urethane part, a thiourethane part, an amide part, an ester part, a thioether part, a sulfonamide part, a urea part, a thiourea part, a secondary amine part, a polyethyleneoxy part represented by $-(CH_2CH_2O)_a-$ (provided that, a represents an integer of 2 or more), an oxycarbonyloxy part, and a partial structure part represented by the following structural formulae ($M^1$ represents as described above).

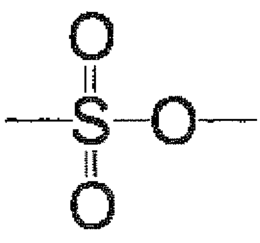
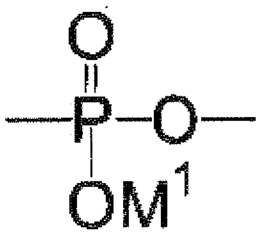

When Z in the above-mentioned formula (IV) represents a trivalent hydrophilic part, preferable examples thereof include a tertiary amine part, a urea part, a thiourea part, and a partial structure represented by the following structural formulae.

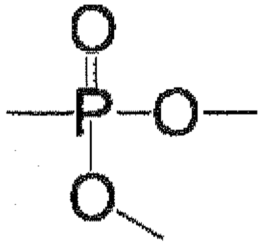

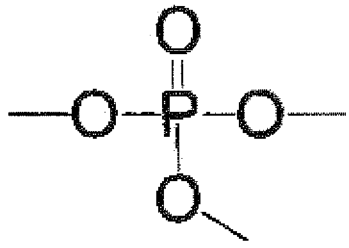

Among the compounds represented by the above-mentioned formula (III), it is more preferable that $R^{11}$ and $R^{12}$ represent a methyl group or an ethyl group, $R^3$ represents a methylene chain having 1 to 5 carbon atoms, or a methylene chain optionally having a substituent and optionally including an oxygen atom in the chain (more preferably a methylene chain having 3 carbon atoms), X represents an amino group; and n represents an integer from 2 to 3 (more preferably 2).

Among the compounds represented by the above-mentioned formula (IV), it is preferable that $R^{11}$ and $R^{12}$ represent a methyl group or an ethyl group, $R^4$ and $R^5$ represent a methylene chain having 1 to 5 carbon atoms (more preferably a methylene chain having 2 carbon atoms), $R^6$ and $R^7$ represent a methylene chain having 1 to 5 carbon atoms (more preferably a methylene chain having 3 carbon atoms), X' represents an amino group, Y, Y' and Z represent an amino group, p represents 0, q represents 1, r represents 0; and n represents an integer from 2 to 3 (more preferably 2).

Specific examples of the specified organic silane compounds represented by the above-mentioned formulae (I) to (IV) are hereinafter shown. However, the invention is not limited thereto.

Examples of the organic silane compounds represented by the above-mentioned formula (I) include β-(3,4-epoxycyclohexyl)ethyltrimethoxysilane, γ-glycidoxypropyltrimethoxysilane, γ-glycidoxypropyltriethoxysilane, methyltrimethoxysilane, methyltriethoxysilane, vinyltriacetoxysilane, γ-chloropropyltrimethoxysilane, vinyltrimethoxysilane, vinyltriethoxysilane, γ-chloropropylmethyldimethoxysilane, trimethylchlorosilane, 2-(3,4-epoxycyclohexyl)ethyltrimethoxysilane, bisallyltrimethoxysilane, tetraethoxysilane, bis(trimethoxysilyl)hexane, and phenyltrimethoxysitane.

Specific examples [exemplified compounds (1) to (149)] of the organic silane compounds represented by the above-mentioned formulae (II), (III) or (IV) as more preferable embodiments are shown.

(1)

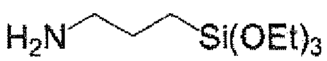

(2)

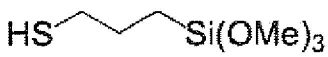

(3)

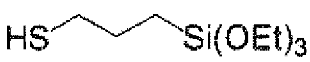

(4)

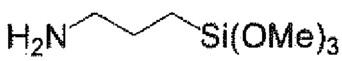

(5)

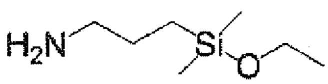

(6)

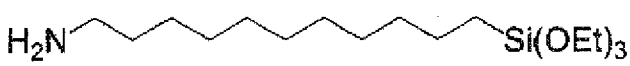

(7)

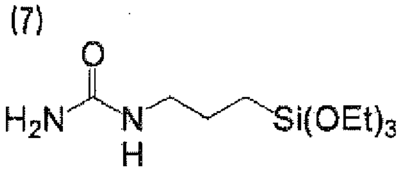

(8)

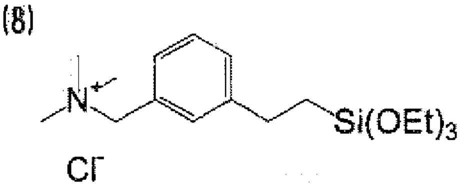

(9)

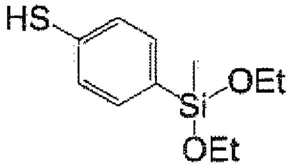

(10)

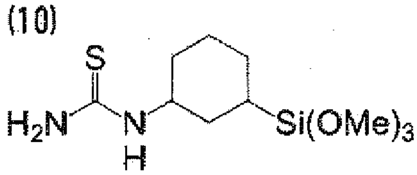

(11)

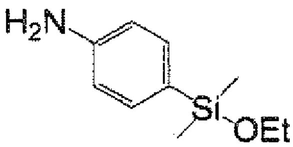

(12)

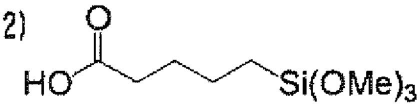

(13)

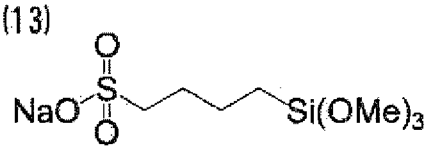

(14)

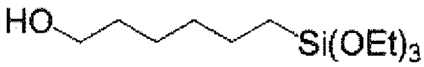

(15)

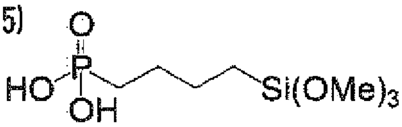

(16)

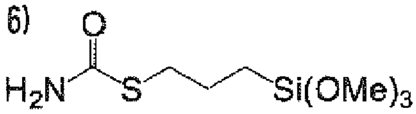

(17)

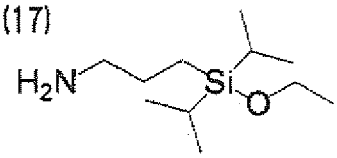

(18)

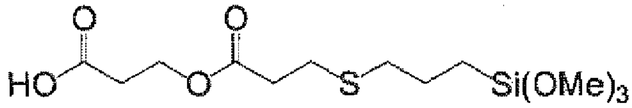

(19)

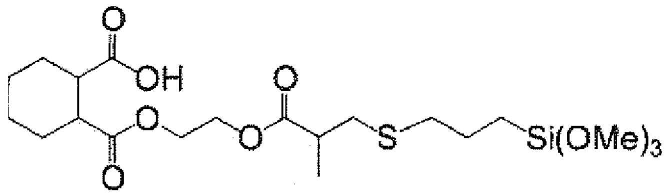

(20)

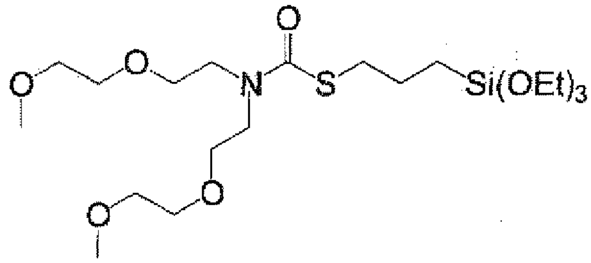

(21)

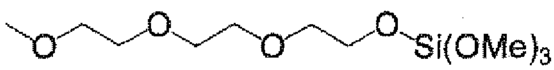

(22)

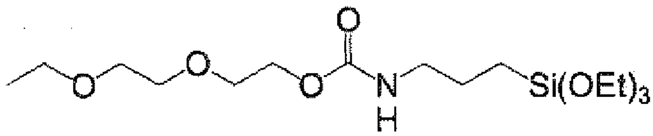

(23)

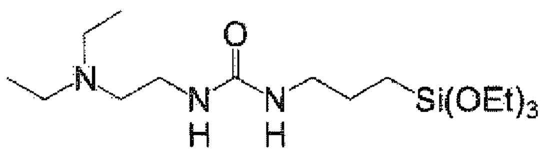

(24)

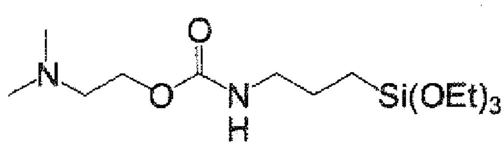

(25)

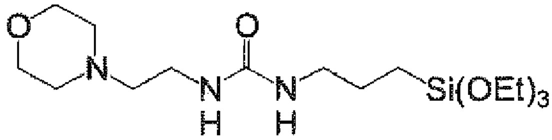

(26)

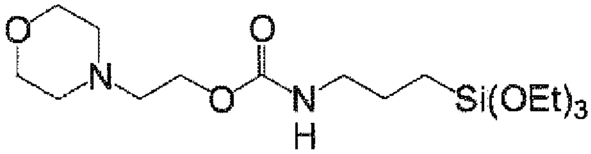

(27)

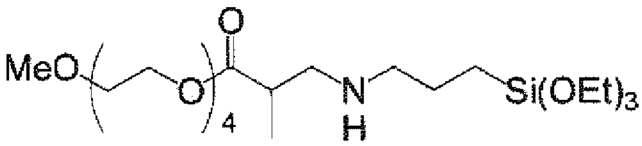

(28)

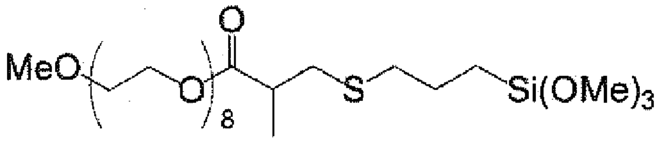

(29)

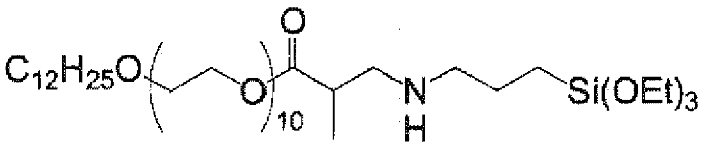

(30)

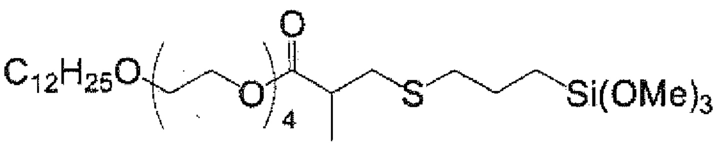

(31)

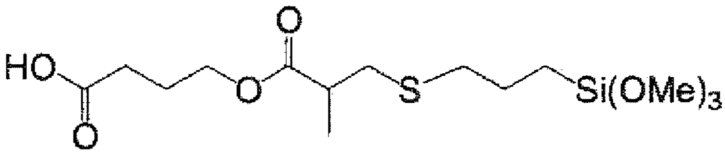

(32)

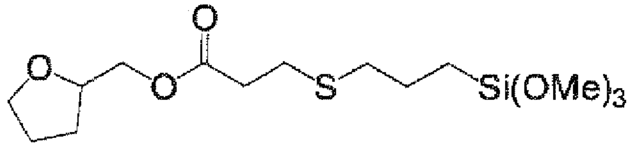

(33)

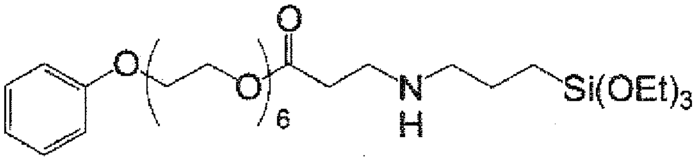

(34)

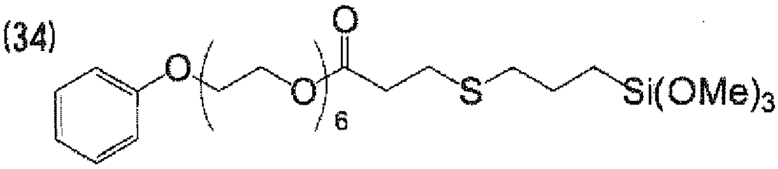

(35)

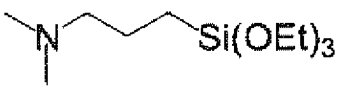

(36)

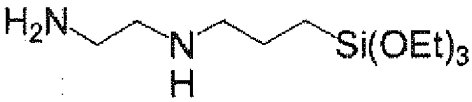

(37)

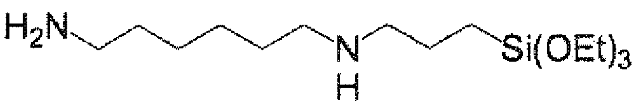

(38)

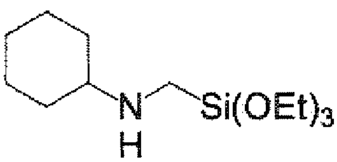

(39)

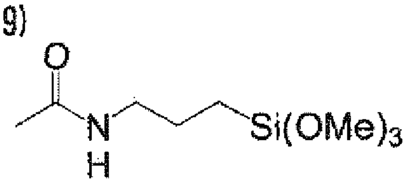

(40)

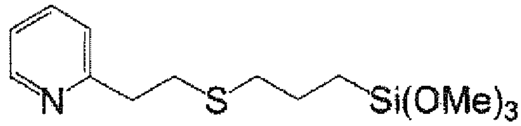

(41)

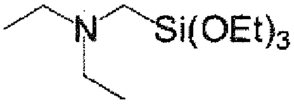

(42)

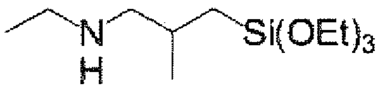

(43)

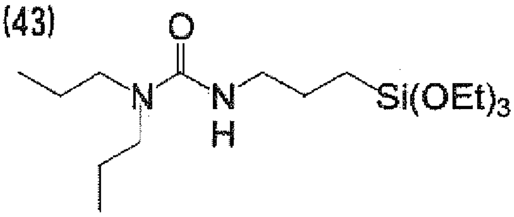

(44)

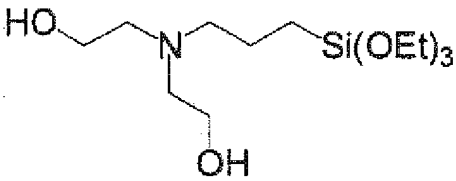

(45)

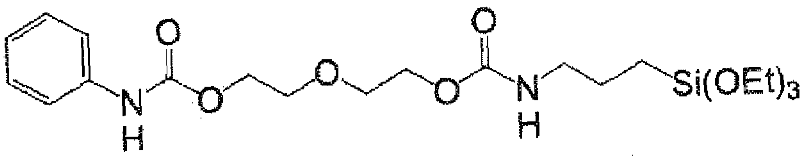

(46)

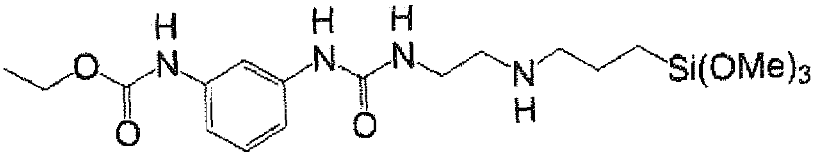

(47)

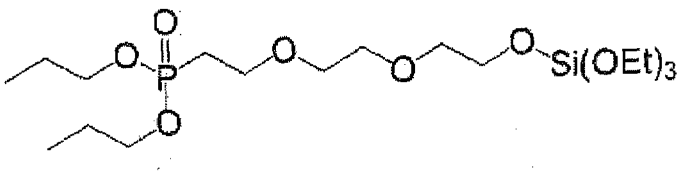

(48)

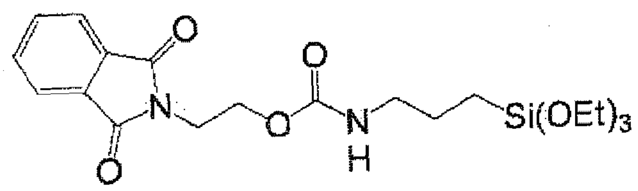

(49)

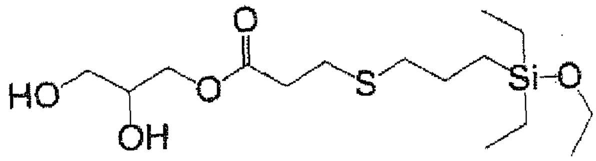

(50)

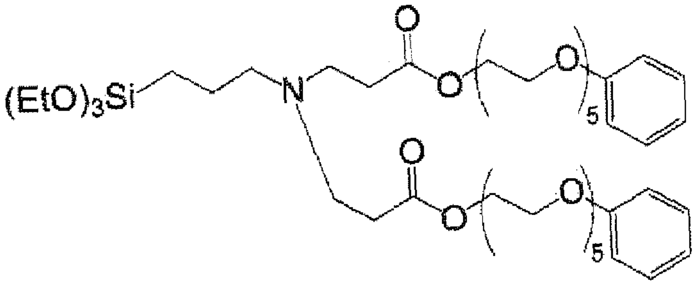

(51)

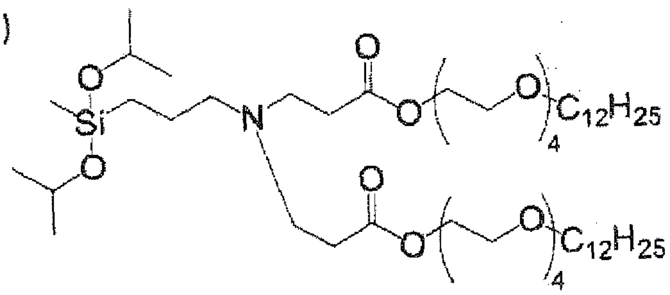

(52)

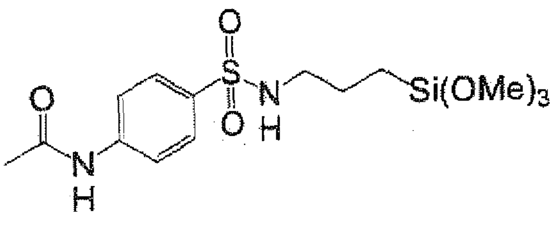

(54)

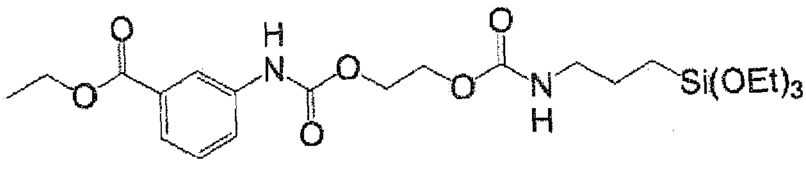

(55)

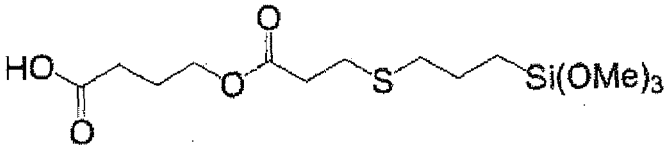

(56)

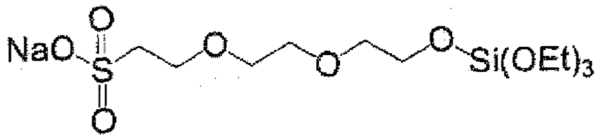

(57)

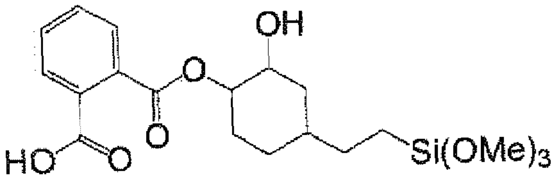

(58)

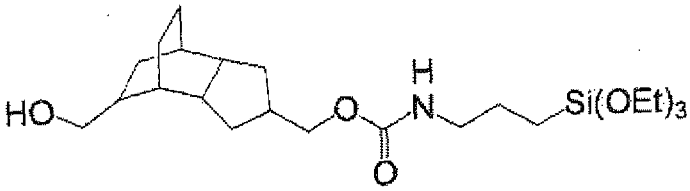

(59)

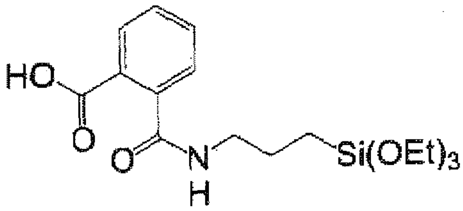

(60)

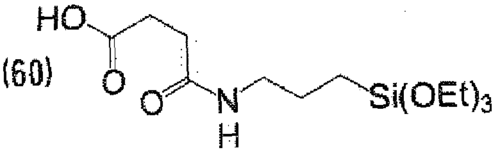

(61)

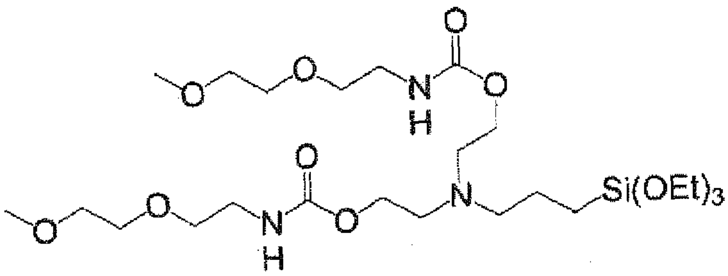

(62)

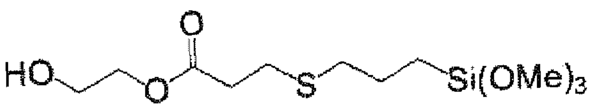

(63)

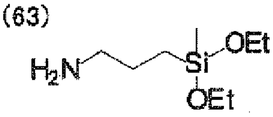

(64)

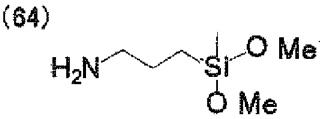

(65)

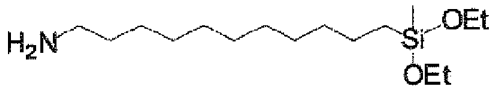

(66)

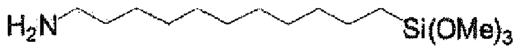

(67)

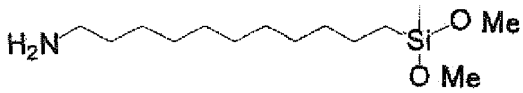

(68)

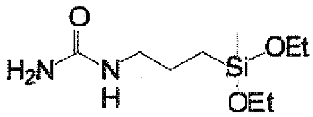

(69)

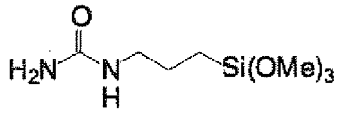

(70)

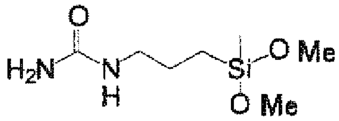

(71)

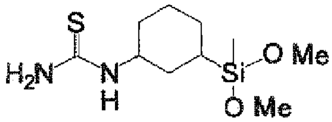

(72)

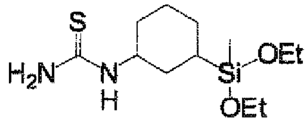

(73)

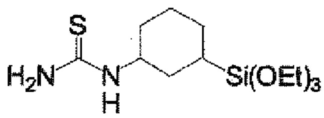

(74)

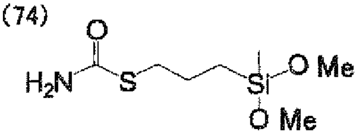

(75)

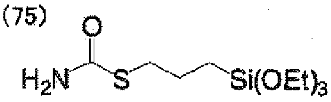

(76)

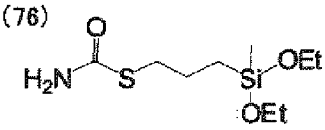

(77)

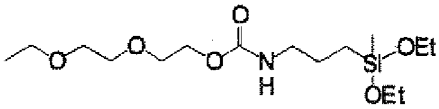

(78)

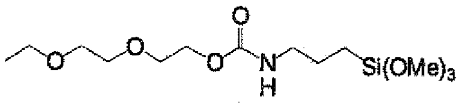

(79)

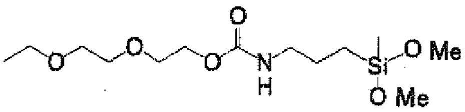

(80)

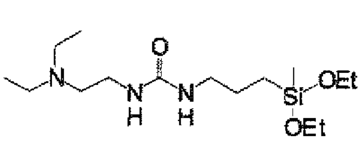

(81)

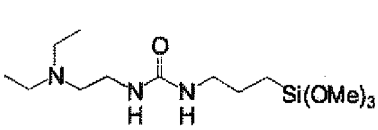

(82)

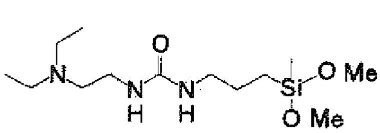

(83)

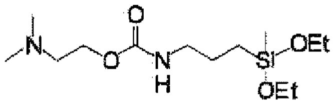

(84)

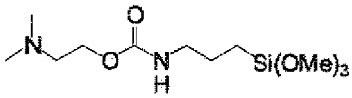

(85)

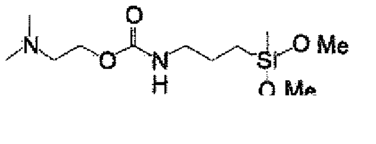

(86)

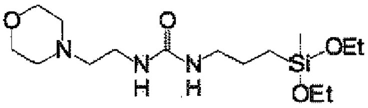

(87)

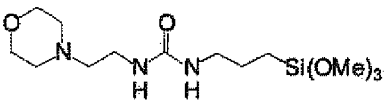

(88)

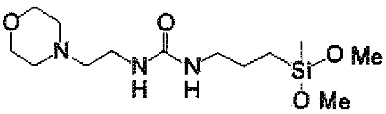

(89)

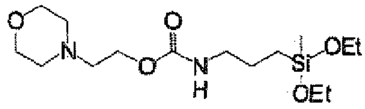

(90)

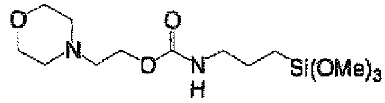

(91)

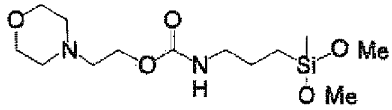

(92)

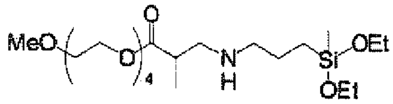

(93)

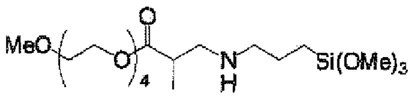

(94)

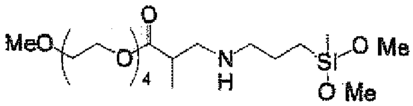

(95)

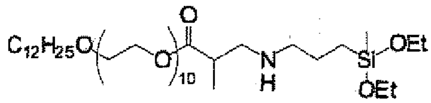

(96)

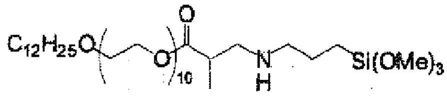

(97)

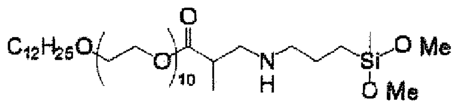

(98)

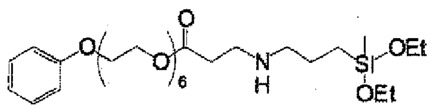

(99)

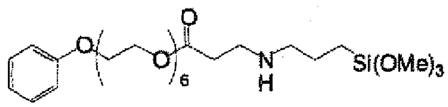

(100)

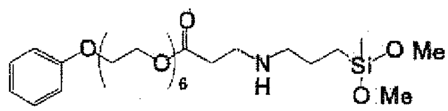

(101)

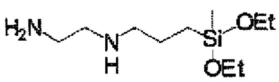

(102)

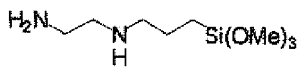

(103)

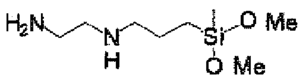

(104)

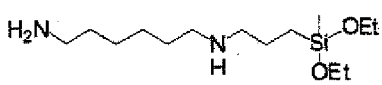

(105)

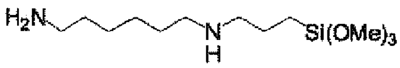

(106)

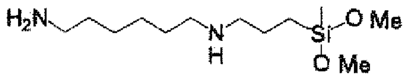

(107)

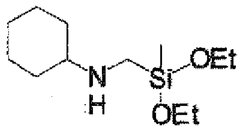

(108)

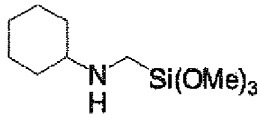

(109)

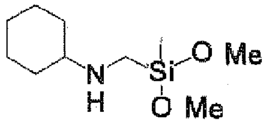

(110)

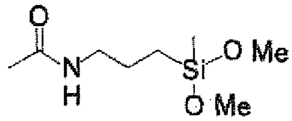

(111)

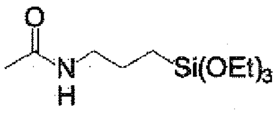

(112)

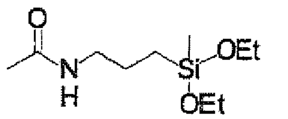

(113)

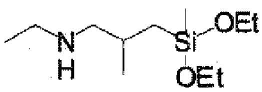

(114)

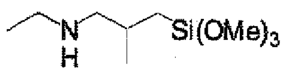

(115)

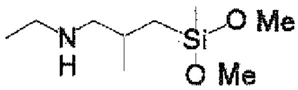

(116)

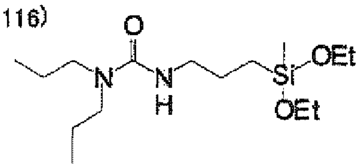

(117)

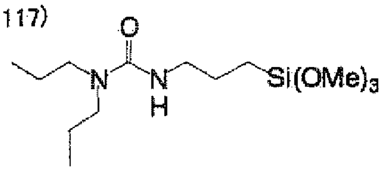

(118)

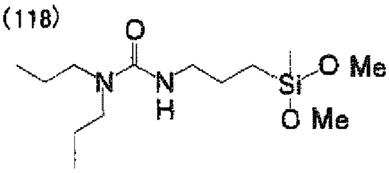

(119)

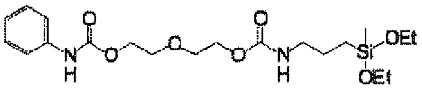

(120)

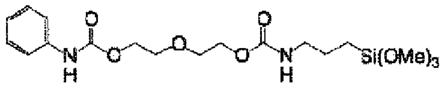

(121)

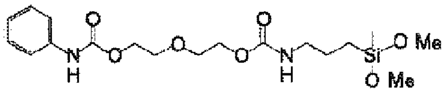

(122)

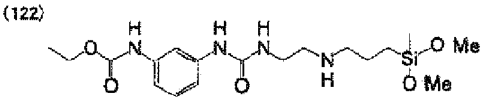

(123)

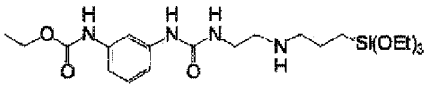

(124)

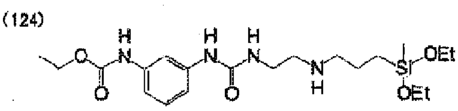

(125)

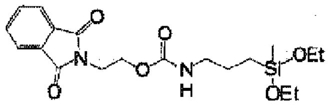

(126)

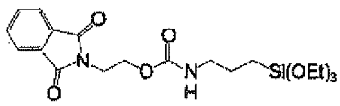

(127)

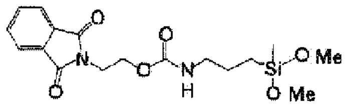

(128)

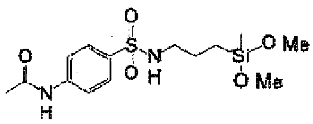

(129)

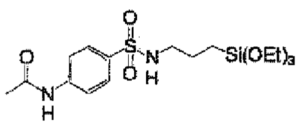

(130)

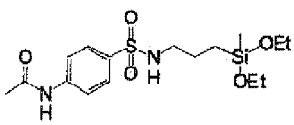

(131)

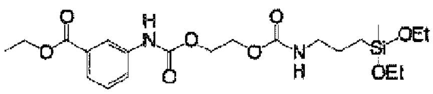

(132)

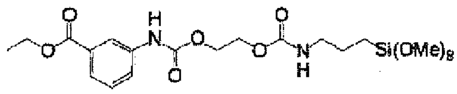

(133)

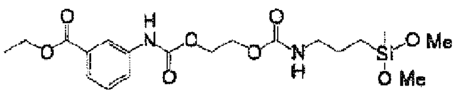

(134)

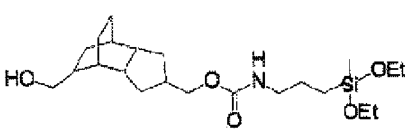

(135)

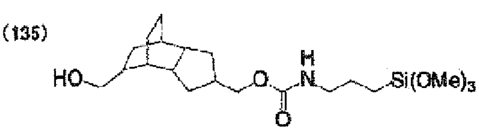

(136) 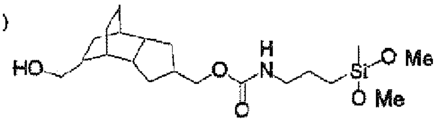

(137) 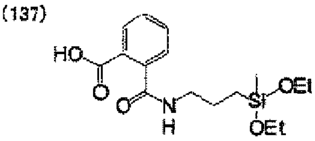

(138) 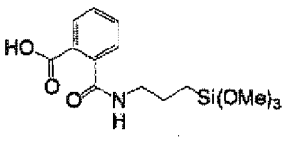

(139) 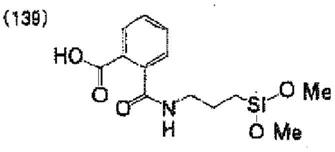

(140) 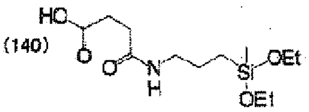

(141) 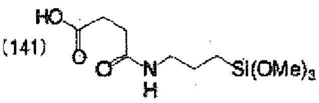

(142) 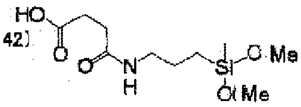

(143) 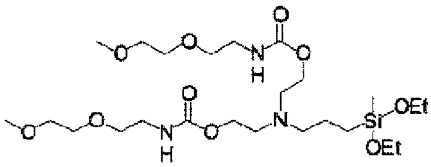

(144) 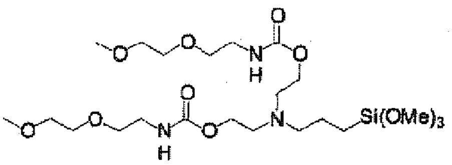

(145) 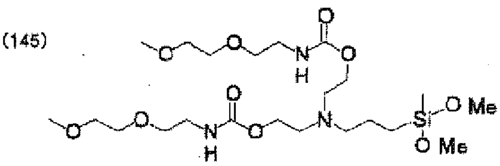

(146) 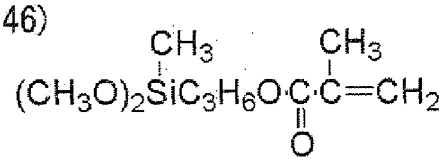

(147) 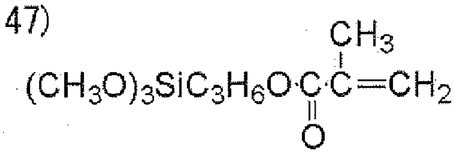

(148) 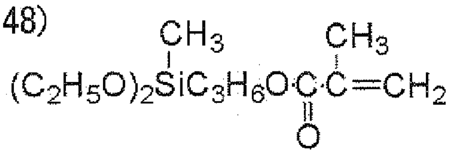

(149) 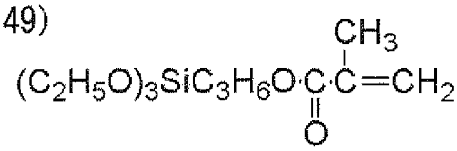

(Non-photosensitive color thermosetting composition)

The above-mentioned non-photosensitive color thermosetting composition contains a coloring agent and a thermosetting composition, and the concentration of the coloring agent in the total solid content is preferably 50% by mass or more and less than 100% by mass. A rise in the coloring agent concentration allows a color filter with a thinner film to be formed.

*Coloring agent*

A coloring agent capable of being used for the invention is not particularly limited, and conventionally known various dyes and pigment may be used while mixed by one kind or two kinds or more.
Examples of the pigments capable of being used for the invention include conventionally known various inorganic pigments or organic pigments. Whether inorganic pigments or organic pigments, in consideration of being preferably high transmittance, pigments with as small an average particle diameter as possible are preferably used; also in consideration of handleability, the average particle diameter of the above-mentioned pigments is preferably 0.01 μm to 0.1 μm, more preferably 0.01 μm to 0.05 μm.
Examples of the pigments capable of being preferably used in the invention include the following. However, the invention is not limited thereto.
C. I. pigment yellow 11, 24, 108, 109, 110, 138, 139, 150, 151, 154, 167, 180, 185;
C. I. pigment orange 36, 71;
C. I. pigment red 122, 150, 171, 175, 177, 209, 224, 242, 254, 255, 264;
C. I. pigment violet 19, 23, 32;
C. I. pigment blue 15:1, 15:3, 15:6, 16, 22, 60, 66;
C. I. pigment green 7, 36, 58;
C. I. pigment black 1

In the invention, when the coloring agent is a dye, a non-photosensitive thermosetting color resin composition may be obtained by uniformly dissolving the dye in the composition.
The dye capable of being used as the coloring agent composing the composition in the invention are not particularly limited, and the dye known as a dye used for conventional color filter may be used.
The following dye may be used as a chemical constitution: pyrazoleazo-based, anilinoazo-based, triphenylmethane-based, anthraquinone-based, anthrapyridone-based, benzylidene-based, oxonol-based, pyrazolotriazoleazo-based, pyridoneazo-based, cyanine-based, phenothiazine-based, pyrrolopyrazoleazomethine-based, xanthene-based, phthalocyanine-based, penzopyran-based, and indigo-based.
The content of the coloring agent in the total solid content of the color thermosetting composition in the invention is not particularly limited, preferably 30 to 60% by mass. The content of 30% by mass or more allows a moderate chromaticity as a color filter. The content of 60% by mass or less allows photo-curing to be sufficiently promoted and restrains film strength as a film from becoming lower.

*Thermosetting compound*

A thermosetting compound capable of being used for the invention is not particularly limited as long as it is able to perform film curing by heating; for example, a compound having a thermosetting functional group may be used. The above-mentioned thermosetting compound is preferably such a compound having at least one group selected from an epoxy group, a methylol group, an alkoxymethyl group and an acyloxymethyl group.
More preferable examples of the thermosetting compound include (a) an epoxy compound, (b) a melamine compound, a guanamine compound, a glycoluril compound or a urea compound, substituted with at least one substituent selected from a methylol group, an alkoxymethyl group and an acyloxymethyl group, and (c) a phenol compound, a naphthol compound or a hydroxyanthracene compound, substituted with at least one substituent selected from a methylol group, an alkoxymethyl group and an acyloxymethyl group. Above all, the above-mentioned thermosetting compound is particularly preferably a polyfunctional epoxy compound.
The total content of the above-mentioned thermosetting compound in the color thermosetting composition varies with the raw material, preferably 0.1 to 50% by mass, more preferably 0.2 to 40% by mass, particularly preferably 1 to 35% by mass with respect to the total solid content (mass) of the thermosetting composition.

*Various additives*

Various additives such as a binder, a curing agent, a curing catalyst, a solvent, a filler, a polymeric compound other than the above, a surfactant, an adhesion accelerator, an antioxidant, an ultraviolet absorbing agent, a aggregation inhibitor, and a dispersant may be blended as required with the color thermosetting composition in the invention unless the effect of the invention is impaired.

*Binder*

The above-mentioned binder is frequently added in preparing pigment dispersion, and does not require alkali-solubility and may be soluble in an organic solvent.
The above-mentioned binder is preferably a linear organic high-molecular-weight polymer soluble in an organic solvent. Examples of such a linear organic high-molecular-weight polymer include a polymer having carboxylic acid in a side chain such as a methacrylic acid copolymer, an acrylic acid copolymer, an itaconic acid copolymer, a crotonic acid copolymer, a maleic acid copolymer and a partially esterified maleic acid copolymer, as described in JP-A No. 59-44615, Japanese Patent Application Publication (JP-B) No. 54-34327, JP-B No. 58-12577, JP-B No. 54-25957, JP-A No. 59-53836 and JP-A No. 59-71048; also, an acidic cellulose derivative having carboxylic acid in a side chain is useful.
Among these various binders, polyhydroxystyrene resin, polysiloxane resin, acrylic resin, acrylamide resin and acryl/acrylamide copolymer resin are preferable from the viewpoint of heat resistance, and acrylic resin, acrylamide resin and acryl/acrylamide copolymer resin are preferable from the viewpoint of controlling developability.
The above-mentioned acrylic resin is preferably a copolymer composed of a monomer selected from benzyl (meth)acrylate, (meth)acrylic acid, hydroxyethyl (meth)acrylate and (meth)acrylamide, such as each copolymer of benzyl methacrylate/methacrylic acid and benzyl methacrylate/benzyl methacrylamide, trade name: KS RESIST-106 (manufactured by Osaka Organic Chemical Industry Ltd.), and trade name: CYCLOMER-P SERIES (manufactured by Daicel Chemical Industries, Ltd.).
The dispersion of the above-mentioned coloring agent in these binders at high concentration allows adhesion to the lower layer, and these contribute to a coated surface state in spin-coating and slit-coating.

*Curing agent*

In the invention, when epoxy resin is used as the thermosetting compound, a curing agent is preferably added. A curing agent for epoxy resin has a wide variety and; property, work life for a mixture of the resin and curing agent, viscosity, curing temperature, curing time and heat generation vary so greatly with the kind of the curing agent to be used. Accordingly, it is required to select appropriate curing agent depending on application purpose, service conditions and working conditions of the curing agent. The above-mentioned curing agent is explained in detail in 'Epoxy Resin (Shoukoudou)' edited by Hiroshi Kakiuchi, Chapter 5. Examples of the above-mentioned curing agent are as follows.
Examples of acting catalytically include tertiary amines and boron trifluoride-amine complex, and examples of reacting stoichiometrically with a functional group of the epoxy resin include polyamine and acid anhydride; examples of cold curing include diethylenetriamine and polyamide resin, and examples of warm curing include diethylaminopropylamine and tris(dimethylaminomethyl)phenol; and examples of hot curing include phthalic anhydride and meta-phenylenediamine. In view of chemical structure, with regard to amines, examples of aliphatic polyamine include diethylenetriamine; examples of aromatic polyamine include meta-phenylenediamine; examples of tertiary amine include tris(dimethylaminomethyl)phenol; examples of acid anhydride include phthalic anhydride, polyamide resin, polysulfide resin and boron trifluoride-monoethylamine complex; and examples of synthetic resin precondensate include phenolic resin and dicyandiamide.
These curing agents are cured in such a manner as to react and polymerize with an epoxy group by heating and thereby the crosslink density is raised. Both binders and curing agents are preferably as small in amount as possible for achieving a thin film, and particularly the curing agents are preferably 35% by mass or less, more preferably 30% by mass or less, still more preferably 25% by mass or less with respect to the thermosetting compound.

*Curing catalyst*

Curing by reaction of epoxy resin mainly with each other in addition to curing by reaction with the above-mentioned curing agent is effective for realizing high concentration of coloring agent in the invention. Thus, a curing catalyst may be also used without using the curing agent. The curing may be performed by as slight an amount as the added amount of the above-mentioned curing catalyst is approximately 1/10 to 1/1000, preferably approximately 1/20 to 1/500, more preferably approximately 1/30 to 1/250 on the basis of mass with respect to the epoxy resin with an epoxy equivalent weight of approximately 150 to 200.

*Solvent*

The color thermosetting composition in the invention may be used as a solution dissolved in various solvents. Each solvent used for the color thermosetting composition in the invention is not particularly limited basically as long as it satisfies solubility of each component and application properties of the color thermosetting composition.

*Dispersant*

The above-mentioned dispersant may be added for improving dispersibility of the pigment. Known dispersants may be used as the above-mentioned dispersant while properly selected; examples thereof include a cationic surfactant, a fluorine-based surfactant and a polymeric dispersant.
Many kinds of compounds are used as these dispersants; examples thereof include a phthalocyanine derivative (commercial product, trade name: EFKA-745 (manufactured by EFKA)), and trade name: SOLSPASS 5000 (manufactured by The Lubrizol Corp.); cationic surfactants such as organosiloxane polymer trade name: KP341 (manufactured by Shin-Etsu Chemical Co., Ltd.), (meth)acrylic acid-based (co)polymer trade name: POLYFLOW No. 75, No. 90 and No. 95 (manufactured by Kyoeisha Chemical Co., Ltd.), and trade name: W001 (manufactured by Yusho Co., Ltd.); nonionic surfactants such as polyoxyethylene lauryl ether, polyoxyethylene stearyl ether, polyoxyethylene oleyl ether, polyoxyethylene octyl phenyl ether, polyoxyethylene nonyl phenyl ether, polyethylene glycol dilaurate, polyethylene glycol distearate and sorbitan fatty acid ester; anionic surfactants such as trade name: W004, W005 and W017 (manufactured by Yusho Co., Ltd.); polymeric dispersants such as trade name: EFKA-46, EFKA-47, EFKA-47EA, EFKA polymer 100, EFKA polymer 400, EFKA polymer 401 and EFKA polymer 450 (manufactured by Morishita & Co., Ltd.), and trade name: DISPERSEAID 6, DISPERSEAID 8, DISPERSEAID 15 and DISPERSEAID 9100 (manufactured by San Nopco Limited); various kinds of SOLSPASS dispersants (manufactured by The Lubrizol Corp.) such as trade name: SOLSPASS 3000, 5000, 9000, 12000, 13240, 13940, 17000, 24000, 26000 and 28000; trade name: ADEKA PLURONIC L31, F38, L42, L44, L61, L64, F68, L72, P95, F77, P84, F87, P94, L101, P103, F108, L121 and P-123 (manufactured by Adeka Corporation), and trade name: ISONET S-20 (manufactured by Sanyo Chemical Industries, Ltd.).
The above-mentioned dispersants may be used singly or in combination of two kinds or more. The added amount of the above-mentioned dispersants in the color thermosetting composition in the invention is ordinarily preferably approximately 0.1 to 50 parts by mass with respect to 100 parts by mass of pigments.

*Other addition agents*

Various kinds of addition agents may be further added as required to the non-photosensitive color thermosetting composition in the invention. Specific examples of the various kinds of addition agents include the various kinds of addition agents described in the above-mentioned color photocurable composition.

<Photoresist>

As described above, in the case that the first to the third color patterns are formed by 'a dry etching method', a resist pattern is formed by using a photoresist. A resist pattern is preferably formed by using a photoresist also in the removing step.
A positive resist composition appropriate for a positive photoresist, which responds to radiations such as ultraviolet rays (g-rays, h-rays and i-rays), far ultraviolet rays including an excimer laser, electron rays, ion beams and X-rays, may be used as the above-mentioned positive photosensitive resin composition. Among the above-mentioned radiations, the above-mentioned photosensitive resin layer is preferably exposed to g-rays, h-rays and i-rays, above all, preferably i-rays in view of the object of the invention.
Specifically, the above-mentioned positive photosensitive resin composition is preferably a composition containing a quinonediazide compound and an alkali-soluble resin. The positive photosensitive resin composition containing a quinonediazide compound and an alkali-soluble resin is used as a positive photoresist by utilizing that a quinonediazide group is decomposed into a carboxyl group by light irradiation with a wavelength of 500 nm or less to consequently shift from alkali-insoluble state to alkali-solubility. This positive photoresist is so remarkably excellent in resolving power as to be used for producing integrated circuits such as IC and LSI. Examples of the above-mentioned quinonediazide compound include a naphthoquinonediazide compound.

<Stopper layer>

The stopper layer of the invention, as described above, is preferably formed by using a curable composition. A composition containing a polymer compound curable by heat may be preferably used as the above-mentioned curable composition. Preferable examples of the above-mentioned polymer compound include a polysiloxane-based polymer and a polystyrene-based polymer. Above all, more preferable examples thereof include a material known as the spin-on-glass (SOG) material, or a thermosetting composition having a polystyrene derivative or a polyhydroxystyrene derivative as the main component.
For example, the Ohnishi parameter (reference documents, JP-A No. 2004-294638 and JP-A No. 2005-146182) may be used as an index for representing resistance to etching of the curable composition for forming the stopper layer.

In the invention, when the parameter value of the color curable composition is 3.5 to 4.5, selectivity for the color curable composition layer may be determined to be securable if the parameter value of the curable composition for forming the stopper layer is 2.5 or less. The Ohnishi parameter may be calculated by the following expression (I).

expression (I) $(C+O+H)/(C-O)$

In the expression (I), C, O and H represent the number of moles of carbon atoms, oxygen atoms and hydrogen atoms, respectively, in a constitutional repeating unit of the polymer. The calculation examples of the Ohnishi parameter are hereinafter shown. In addition, the calculation was performed while omitting three digits after the decimal point.
Example 1. fluorine-based acrylate compound

$$(C+O+H)/(C-O)=(33+6+25)/(33-6)=2.37$$

Example 2. polyhydrostyrene derivative

$$(C+O+H)/(C-O)=(8+1+8)/(8-1)=2.42$$

The color filter produced by the method for producing a color filter described above may be used for a liquid crystal display device and a solid-state imaging device such as CCD and CMOS, and is particularly appropriate for a solid-state imaging device with a high resolution over one million pixels. The color filter of the invention may be used as a color filter disposed between a light-receiving unit of each pixel composing CCD and CMOS and a microlens for concentrating light.
Above all, the color filter is used more appropriately for a solid-state imaging device with a color pixel size of 1.7 μm or less, and used particularly appropriately for a solid-state imaging device with a color pixel size of 1.5 μm or less.

<Solid-state imaging device>

The solid-state imaging device of the invention is composed while provided with the above-mentioned color filter of the invention.
The solid-state imaging device of the invention is excellent in color reproductivity by reason of being provided with the color filter of the invention excellent in rectangularity of the color pixel.
The constitution of the solid-state imaging device of the invention is not particularly limited as long as it is a constitution provided with the color filter of the invention and a constitution for functioning as a solid-state imaging device; examples thereof include the following constitution.
The constitution is a constitution such as to have plural photodiodes and a transfer electrode made of polysilicon and the like composing a light-receiving area of the solid-state imaging device (such as a CCD image sensor and a CMOS image sensor) on a support, have a light-shielding film made of tungsten and the like open to only the light-receiving unit of the photodiodes on the above-mentioned photodiodes and the above-mentioned transfer electrode, have a device protective film made of silicon nitride and the like formed so as to cover the whole light-shielding film and the photodiode light-receiving unit on the light-shielding film, and have the color filter of the invention on the above-mentioned device protective film.
In addition, the constitution may be also a constitution such as to have a light concentrating unit (such as a microlens, and so forth) on the above-mentioned device protective layer and below the color filter (on the side near to the support), and a constitution such as to have a light concentrating unit on the color filter.

EXAMPLES

The invention is hereinafter described more specifically by examples and is not limited to the following examples unless it deviates from the spirit thereof. 'Part' is on the basis of mass unless otherwise specified.
Then treatment by using commercial treatment liquid is performed in each of the following steps, the treatment was performed in accordance with the method determine by the manufacture maker of each treatment liquid unless otherwise specified.

[Example 1]

A color filter was produced in an exemplary embodiment of forming the first and the third color patterns by a photolithographic method (the first exemplary embodiment). The detailed producing method is hereinafter described.

<First color pattern forming step>

A blue (B) photocurable composition "trade name: SB-5000L" (manufactured by FUJIFILM Electronic Materials Co., Ltd.) was applied on a silicon substrate into an applied film with a thickness of 0.8 μm by a spin coater, and thereafter prebake treatment was performed at an applied film temperature or an atmospheric temperature of 100°C for 2 minutes by using a hot plate to obtain a color layer B as a first color layer.

Subsequently, the color layer B was subjected to pattern exposure at an exposure amount of 200 mJ/$cm^2$ by using an i-ray stepper (manufactured by Canon Inc.) and subjected to development treatment for 1 minute by using developer "trade name: CD-2060" (manufactured by FUJIFILM Electronic Materials Co., Ltd.), and thereafter subjected to rinse treatment by using pure water and drying treatment by spin dry. Thereafter, the color layer B was further subjected to postbake treatment at a temperature of 220°C for 5 minutes, to form a B pattern serving as a first color pattern in a desired pattern area intended for forming the B pattern.

Here, the B pattern was formed as a stripe pattern. With regard to the size of LINE&SPACE of the B pattern, LINE was 1.5 μm and SPACE was 1.5 μm, and the film thickness after the postbake treatment was 0.7 μm.

In the Examples, 'LINE' signifies the line width of the pattern and 'SPACE' signifies the width of an area with no patterns formed, which was held between two patterns (and so forth).

<Second color layer forming step>

Next, a red (R) photocurable composition "trade name: SR-5000L" (manufactured by FUJIFILM Electronic Materials Co., Ltd.) was applied on the above-mentioned silicon substrate on the side, on which the B pattern has been formed, into an applied film with a thickness of 0.7 μm, and thereafter prebake treatment was performed at an applied film temperature or an atmospheric temperature of 100°C for 2 minutes by using a hot plate to obtain a color layer R as a second color layer. Subsequently, postbake treatment was performed at a temperature of 220°C for 5 minutes.

The color layer R was embedded between the striped B patterns and formed so as to cover the B patterns.

Subsequently, a positive photoresist "trade name: FHi622BC" (manufactured by FUJIFILM Electronic Materials Co., Ltd.) was applied on the above-mentioned silicon substrate on the side, on which the B pattern and the color layer R have been formed, and performed prebake treatment and formed a photoresist layer with a thickness of 1.2 μm.

Subsequently, the photoresist layer on a pattern area intended for forming a G pattern (G pixel) in the B pattern and the color layer R was subjected to pattern exposure at an exposure amount of 350 mJ/$cm^2$ by using an i-ray stepper (manufactured by Canon Inc.) and performed heat treatment at a photoresist layer temperature or an atmospheric temperature of 90°C for 1 minute. Thereafter, development treatment was performed for 1 minute by using developer "trade name: FHD-5" (manufactured by FUJIFILM Electronic Materials Co., Ltd.), and postbake treatment was further performed at a temperature of 110°C for 1 minute, to form a resist pattern by removing the photoresist in an area intended for forming a G pattern (G pixel). In the formed resist pattern, the area intended for forming a G pattern (G pixel) was an aperture pattern of a 1.5-μm square and the array thereof was an array in a check pattern.

<Removing step>

Next, dry etching treatment was performed on the following conditions to remove the area intended for forming a G pattern (G pixel) in the B pattern and the color layer R.

First, the dry etching treatment in the first stage was performed for 90 seconds with dry etching equipment ("trade name: U-621", manufactured by Hitachi High-Technologies Corporation) on the conditions of RF power: 800 W, antenna bias: 400 W, wafer bias: 200 W, internal pressure of chamber: 4.0 Pa, substrate temperature: 50°C, and gas kind and flow rate of mixed gas: $CF_4$: 80 mL/min., $O_2$: 40 mL/min., Ar: 800 mL/min.

In the conditions of the above-mentioned dry etching treatment in the first stage, the scraped amount of the B pattern area was 500 nm and the scraped amount of the color layer R area was 635 nm; in the first etching, the B pattern and the R pattern offered an etching amount of 71% and 91%, respectively. The state is such that the residual films of 200 nm and 65 nm remain on the support, respectively.

Subsequently, the etching treatment in the second stage and the over-etching treatment were performed with the same etching chamber on the conditions of RF power: 600 W, antenna bias: 100 W, wafer bias: 250 W, internal pressure of chamber: 2.0 Pa, substrate temperature: 50°C, gas kind and flow rate of mixed gas: $N_2$: 500 mL/min., $O_2$: 50 mL/min., Ar: 500 mL/min ($N_2$/$O_2$/Ar=10/1/10), and over-etching rate in the total etching: 20%.

In the conditions of the above-mentioned dry etching treatment in the second stage, the etching rate of the B pattern and the etching rate of the color layer R were both 600 nm/min or more; it took approximately 10 to 20 seconds to etch the residual films of the B pattern and the color layer R. The addition of 90 seconds as the first etching time and 20 seconds as the second etching time was calculated as the etching time. As a result, the etching time was 90+20=110 seconds, the over-etching time was 110×0.2=22 seconds, and the total etching time was 110+22=132 seconds.

As described above, the area intended for forming a G pattern (G pixel) in the B pattern and the color layer R was removed by dry etching to obtain a B pixel and an R pixel.

Next, peeling treatment was performed for 120 seconds by using photoresist peeling liquid "trade name: MS-230C" (manufactured by FUJIFILM Electronic Materials Co., Ltd.) to remove the photoresist. Thereafter, postbake treatment was performed at a temperature of 100°C for 2 minutes.

Here, the R pattern was laminated on the B pixel.

<Third color pattern forming step>

Next, a photocurable composition as a G pattern "trade name: SG-5000L" (manufactured by FUJIFILM Electronic Materials Co., Ltd.) was applied on the above-mentioned silicon substrate on the side, on which the R pixel and the B pixel have been formed, into an applied film with a thickness of 0.6 μm, and thereafter prebake treatment was performed at an applied film temperature of 100°C for 2 minutes by using a hot plate to obtain a color layer G as a third color layer.

Subsequently, the color layer G was subjected to pattern exposure at an exposure amount of 200 $mJ/cm^2$ by using an i-ray stepper (manufactured by Canon Inc.) and thereafter subjected to development treatment for 1 minute by using developer "trade name: CD-2060" (manufactured by FUJIFILM Electronic Materials Co., Ltd.), and thereafter subjected to rinse treatment by pure water and drying treatment by spin dry. Thereafter, the color layer G was further subjected to postbake treatment at a temperature of 220°C for 5 minutes, to form a G pattern (G pixel) serving as the third color pattern in a desired pattern area intended for forming the G pattern (G pixel).

The G pattern (G pixel) was formed into a check pattern of a 1.5-μm square so as to be embedded in the area processed by the above-mentioned etching. The array of the G pixel was a check pattern.

Subsequently, the R pattern laminated on the B pixel was removed by performing CMP treatment (flattening treatment) on the following conditions.

That is, polishing was performed until the B pixel was exposed with the use of a CMP polishing apparatus ("trade name: BC-15", manufactured by KEMET Corp.) by using diluent of "trade name: Semisperse25" (manufactured by Cabot Corp.): pure water=1:10 as a slurry and a continuous foaming type ("trade name: WHITEX SERIES", manufactured by KEMET Corp.) as a polishing pad on the conditions of slurry flow rate: 150 mL/min, wafer pressure: 2.0 psi, and retainer ring pressure: 1.0 psi.

The overpolishing was determined at 10%.

The substrate surface was formed into a flat state by the above treatments. That is, any of the R pixel upper side surface, the B pixel upper side surface and the G pixel upper side surface was on the same level with the silicon substrate. The film thickness was 0.6 μm.

According to the above, a color filter array having the R pixel, the G pixel and the B pixel was obtained.

In the obtained color filter array, an area with no color pixels formed was restrained from occurring in an area in which corners of each of the color pixels (the R pixel, the G pixel and the B pixel) come together, and also a spot where a film thickness of the color pixels is thin was restrained from occurring in the vicinity of the boundary line between the color pixels. This result represents that the use of the above-mentioned method for producing the color filter allows pattern formation limitation to be improved and allows a finer pattern to be formed.

[Example 2]

A color filter was produced according to an exemplary embodiment of forming the first and the third color patterns by a dry etching method (the second exemplary embodiment). The example is an exemplary embodiment of having a stopper layer. The detailed producing method is hereinafter described.

<First color pattern forming step>

A red thermosetting composition "trade name: RED" (manufactured by FUJIFILM Electronic Materials Co., Ltd.) was applied on a silicon substrate into an applied film with a thickness of 0.5 μm by a spin coater, and thereafter heating was performed at a temperature of 220°C for 5 minutes by using a hot plate, to form a color layer R serving as a first color layer by curing the applied film. The film thickness of the color layer R formed by using the RED was 0.5 μm.

Subsequently, a thermosetting composition "trade name: 1TS-54S-300A" (manufactured by Rasa Industries,

Ltd.) was applied on the above-mentioned silicon substrate on the side, on which the color layer R has been formed, into a thickness of 30 nm by a spin coater, and thereafter heat treatment was performed at a temperature of 220°C for 5 minutes, to form a thin transparent film 1 serving as a stopper layer on the color layer R by curing.

Subsequently, a positive photoresist "trade name: FHi622BC" (manufactured by FUJIFILM Electronic Materials Co., Ltd.) was applied on the thin transparent film 1 and performed prebake treatment and formed a photoresist layer with a thickness of 1.0 μm.

Subsequently, the photoresist layer in a pattern area intended for removing the R pattern was subjected to pattern exposure at an exposure amount of 350 mJ/cm$^2$ by using an i-ray stepper (manufactured by Canon Inc.) and performed heat treatment at a photoresist layer temperature or an atmospheric temperature of 90°C for 1 minute. Thereafter, development treatment was performed for 1 minute by using developer "trade name: FHD-5" (manufactured by FUJIFILM Electronic Materials Co., Ltd.), and postbake treatment was further performed at a temperature of 110°C for 1 minute so as to form a resist pattern as an etching mask by removing the photoresist in a desired pattern area intended for removing the R pattern.

Here, the resist pattern was a stripe pattern, and the size of LINE&SPACE in the stripe pattern was formed into LINE. 1.6 μm and SPACE: 1.4 μm in consideration of etching conversion difference (contraction of the pattern width by etching).

Next, the thin transparent film 1 and the color layer R were subjected to dry etching in the following manner by using the resist pattern formed in the above as an etching mask to produce the R pattern as the first color pattern.

First, the first etching treatment was performed for 73 seconds with dry etching equipment ("trade name: U-621", manufactured by Hitachi High-Technologies Corporation) on the conditions of RF power: 800 W, antenna bias: 400 W, wafer bias: 200 W, internal pressure of chamber: 4.0 Pa, substrate temperature: 50°C, and gas kind and flow rate of mixed gas: $CF_4$: 80 mL/min., $O_2$: 40 mL/min., Ar: 800 mL/min.

The scraped amount of the color layer R on these conditions was 423 nm; the scraped amount in the first etching offered an etching amount of 91%, and the state was such that the residual film of 77 nm remained by reason of requiring etching time of the thin transparent film 1: approximately 3 seconds.

Subsequently, the etching treatment was performed with the same etching chamber on the conditions of RF power: 600 W, antenna bias: 100 W, wafer bias: 250 W, internal pressure of chamber: 2.0 Pa, substrate temperature: 50°C, gas kind and flow rate of mixed gas: $N_2$: 500 mL/min., $O_2$: 50 mL/min., Ar: 500 mL/min ($N_2/O_2$/Ar=10/1/10), and over-etching rate in the total etching: 20%.

The etching rate of the color layer R in the second etching conditions was 600 nm/min or more; it took approximately 10 seconds to etch the residual film of the color layer R. The addition of 90 seconds as the first etching time and 10 seconds as the second etching time was calculated as the etching time. As a result, the etching time was 73+10=83 seconds, the over-etching time was 83×0.2=17 seconds, and the total etching time was 83+17=100 seconds.

After performing the dry etching on the above-mentioned conditions, peeling treatment was performed for 120 seconds by using photoresist peeling liquid "trade name: MS230C" (manufactured by FUJIFILM Electronic Materials Co., Ltd.) to remove the photoresist and obtained the R pattern having the thin transparent film 1 in the upper layer as the first color pattern.

Here, the R pattern was formed as a stripe pattern. With regard to the size of LINE&SPACE, LINE was 1.5 μm and SPACE was 1.5 μm.

<Second color layer forming step>

Next, a blue thermosetting composition "trade name: BLUE" (manufactured by FUJIFILM Electronic Materials Co., Ltd.) was applied on the above-mentioned silicon substrate on the side, on which the thin transparent film 1 and the R pattern have been formed, into an applied film with a thickness of 0.5 μm by a spin coater, and thereafter heating was performed at a temperature of 220°C for 5 minutes by using a hot plate, to form a color layer B serving as the second color layer by curing the applied film.

Subsequently, a positive photoresist "trade name: FHi622BC" (manufactured by FUJIFILM Electronic Materials Co., Ltd.) was applied on the above-mentioned formed color layer B and performed prebake treatment and formed a photoresist layer with a thickness of 1.0 μm. Thereafter, the pattern exposure and development treatment were performed on the same conditions as the resist pattern formation in the above-mentioned first color pattern forming step that forms a resist pattern by removing the photoresist in a pattern area intended for forming a G pattern (G pixel). In the formed resist pattern, the area intended for forming a G pattern (G pixel) was an aperture pattern of a 1.5-μm square and the array thereof was an array in a check pattern.

<Removing step>

Subsequently, the dry etching treatment was performed on the same conditions as the removing step of Example 1 except for modifying the total etching time into 138 seconds by modifying the etching time in the first stage, the etching

time in the second stage and the over-etching time into 95 seconds, 20 seconds and 23 seconds, respectively so as to remove the area for forming a G pattern (G pixel) in the thin transparent film 1, the R pattern and the color layer B by dry etching.

As described above, the area intended for forming a G pattern (G pixel) in the R pattern and the color layer B was removed by dry etching to obtain an R pixel and a B pixel.

Next, peeling treatment was performed for 120 seconds by using photoresist peeling liquid "trade name: MS-230C" to remove the resist pattern.
Here, the thin transparent film I and the B pattern were laminated on the R pixel.

<Third color pattern forming step>

Next, a thermosetting composition as a G pattern "trade name: GREEN" (manufactured by FUJIFILM Electronic Materials Co., Ltd.) was applied on the above-mentioned silicon substrate on the side, on which the R pixel, the B pixel and the thin transparent film 1 have been formed, into an applied film with a thickness of 0.5 μm, and thereafter postbake treatment was performed at an applied film temperature of 220°C for 5 minutes by using a hot plate to obtain a color layer G as the third color layer. The film thickness of the B pattern and the film thickness of the color layer G on the stopper layer were each 100 nm.

Next, in the etch back treatment on the following conditions, a G pattern (G pixel) as the third color pattern was formed and the B pattern which has been further laminated on the thin transparent film 1 on the R pixel was removed. That is, the whole etching (the etch back treatment) was performed until the thin transparent film 1 was exposed with dry etching equipment ("trade name: U-621", manufactured by Hitachi High-Technologies Corporation) on the conditions of RF power: 600 W, antenna bias: 100 W, wafer bias: 250 W, internal pressure of chamber: 2.0 Pa, substrate temperature: 50°C, and gas kind and flow rate of mixed gas: $N_2$: 500 mL/min., Ar: 500 mL/min ($N_2$/Ar=1/1).
Then, the etching rate of the color layer G and the B pattern was both 150 nm/min, and it was calculated that it took 80 seconds (the time for removing both G and B) to expose the thin transparent film 1. The etching time was obtained by adding the over-etching for 10 seconds thereto. As a result, the etching time was 80 seconds, the over-etching time was 10 seconds, and the total etching time was 80+10=90 seconds.

According to the above, a G pattern (G pixel) as the third color pattern was formed in a desired pattern area intended for forming the G pattern (G pixel). The B pattern which has been further laminated on the thin transparent film 1 on the R pixel was removed in the same etch back treatment.
The G pattern (G pixel) was formed into a check pattern of a 1.5-μm square in such a manner that the G pattern is embedded in the area processed by the above-mentioned etching. The array of the G pixel was a check pattern.
The substrate surface was formed into a flat state within Δ0.1 μm (the difference between the film thickness maximum and the film thickness minimum was within Δ0.1 μm). That is, the total thickness of the R pixel and the stopper layer was 0.50 μm, the B pixel was 0.49 μm and the G pixel was 0.49 μm. In the B pixel and the G pixel, a decreased film of 0.01 μm from the completion of the film formation was the scraped amount by over-etching.

According to the above, a color filter array having the R pixel, the G pixel and the B pixel was obtained.
In the obtained color filter array, an area with no color pixels formed was restrained from occurring in an area in which corners of each of the color pixels (the R pixel, the G pixel and the B pixel) come together, and also a spot where a film thickness of the color pixels is thin was restrained from occurring in the vicinity of the boundary line between the color pixels. This result represents that the use of the above-mentioned method for producing the color filter allows pattern formation limitation to be improved and allows a finer pattern to be formed.

The above-mentioned Example 1 and Example 2 offer a difference in the method for forming the first color pattern between the photolithographic method and the dry etching method, and a difference in the treatment in the third color pattern forming step between the CMP treatment and the etch back treatment; both of these methods and treatments are methods and treatments to be performed for the same object, so that there are no restrictions on which methods and treatments to apply, and an embodiment of combining both may be performed.
For example, in the case that the method for forming the first color pattern in Example 1 is shifted from the photolithographic method to the dry etching method and the CMP treatment in the third color pattern forming step is shifted to the etch back treatment (or the treatment of using the etch back and the CMP together), the same effect as Example 1 can be obtained. Also, in the case that the method for forming the first color pattern in Example 2 is shifted from the dry etching method to the photolithographic method and the etch back treatment in the third color pattern forming step is shifted to the CMP treatment (or the treatment of using the etch back and the CMP together), the same effect as Example 2 can be obtained.

With regard to the color filter formed by the conventional photolithographic method, the basis of the formation of the G pattern, the R pattern and the B pattern is an island pattern (an isolated pattern) (G is a check pattern), and the formability of the patterns is inferior to LINE & SPACE due to the proximity effect in exposing. In particular, it is known that the color composition applied to the color filter material is inferior in rectangularity of the patterns to a general

photoresist. In order to compensate for this rectangularity, the first color pattern is formed as striped LINE & SPACE, the second color layer is only formed into a film, and the island pattern formation for forming a color filter array adopts photoresist and dry etching treatment excellent in resolution, so that a color filter with exellent rectangularity more than conventionally may be formed.
As a result, pattern formability may be improved, and particularly pattern formation limitation in the case of forming the color pattern by the photolithographic method may be improved and a finer pattern may be formed.

In the above, an example such that the color filter (the color pixels of R, G and B) was formed on the silicon substrate was described in Examples 1 and 2; in the case of producing a solid-state imaging device, the above-mentioned silicon substrate may be replaced with a substrate for a solid-state imaging device, on which a photodiode, a light-shielding film and a device protective film may be formed.
For example, a solid-state imaging device (such as CCD and CMOS) favorable in color reproductivity may be produced in such a manner that a light-shielding film made of tungsten open to only a light-receiving unit of a photodiode is formed on a silicon substrate with a photodiode and a transfer electrode formed, a device protective layer made of silicon nitride is formed so as to cover the formed whole light-shielding film and photodiode light-receiving unit (the opening unit in the light-shielding film), a color filter (color pixels of R, G and B) is formed on the formed device protective layer by the same method as Examples 1 and 2, and a microlens serving as a light concentrating unit is formed on the formed color filter.

## Claims

**1.** A method for producing a color filter comprising:

(a) a step of forming a first color pattern in a stripe shape on a support;
(b) a step of forming a second color layer on the support on which the first color pattern has been formed;
(c) a step of removing an area for forming a third color pattern in the first color pattern and/or the second color layer by dry etching; and
(d) a step of forming the third color pattern in the area, from where the first color pattern and/or the second color layer have been removed, on the support.

**2.** The method for producing a color filter of claim 1, wherein formation of the first color pattern is performed by a method for forming a first color layer on the support and exposing and developing the formed first color layer, or a method for forming a first color layer on the support to form a resist pattern on the formed first color layer by using a photoresist and dry-etching the first color layer by using the formed resist pattern as an etching mask.

**3.** The method for producing a color filter of claim 1, wherein:

formation of the third color pattern is performed by a method for forming a third color layer on the support after (c) the step of removing, and exposing and developing the formed third color layer; and
the method further comprises a step of flattening at least the formed third color pattern and the second color layer where the area for forming the third color pattern has been removed.

**4.** The method for producing a color filter of claim 1, wherein formation of the third color pattern is performed by forming a third color layer on the support after (c) the step of removing, and flattening at least the formed third color layer and the second color layer where the area for forming the third color pattern has been removed.

**5.** The method for producing a color filter of claim 3, wherein the step of flattening is an etch back treatment that etches the whole exposed plane of the formed color layer and/or a polishing treatment that polishes the whole exposed plane of the formed color layer.

**6.** The method for producing a color filter of claim 3, wherein the step of forming the first color pattern (a) includes a step of forming a first color layer on the support and a step of forming a stopper layer on the formed first color layer; in the step of removing (c), the area for forming the third color pattern in the first color pattern and/or the second color layer is removed together with an area for forming the third color pattern in the stopper layer; and
in the flattening step, flattening is performed until the stopper layer is exposed.

**7.** A color filter that is formed by using the method of claim 1.

**8.** A solid-state imaging device that includes the color filter of claim 7.

FIG.1A

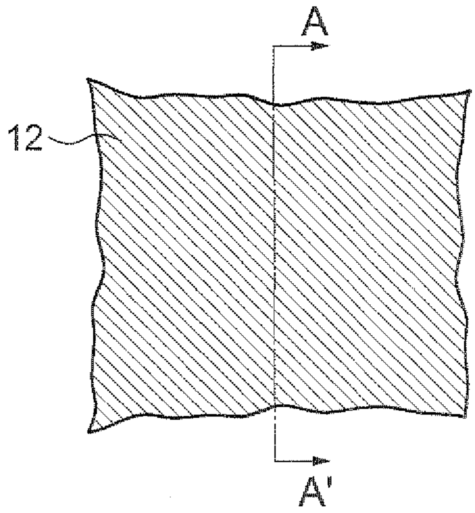


FIG.1B

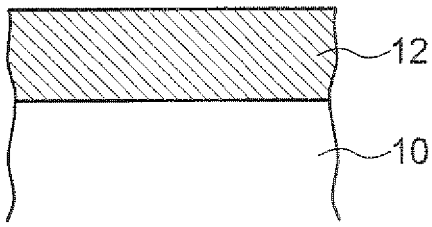

FIG.2A

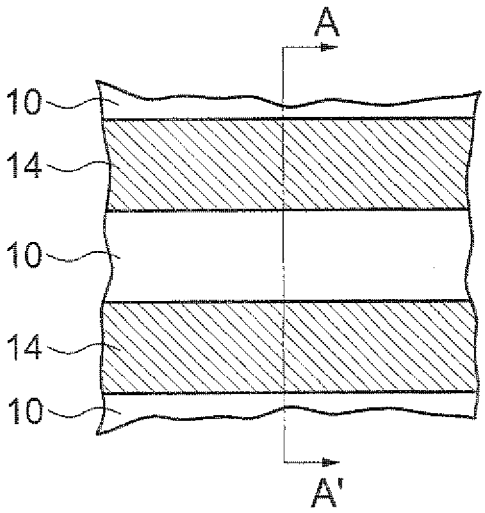


FIG.2B

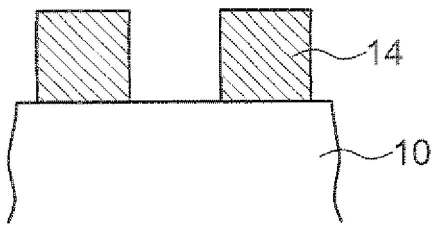

FIG.3A

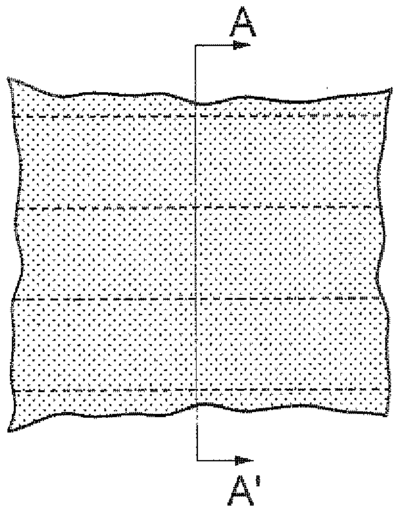


FIG.3B

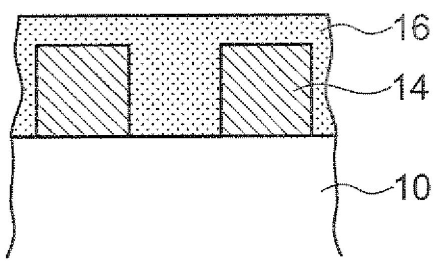

FIG.4A

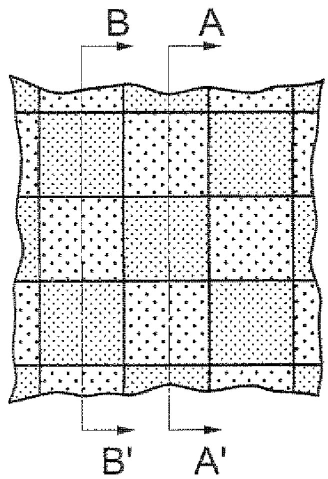


FIG.4B

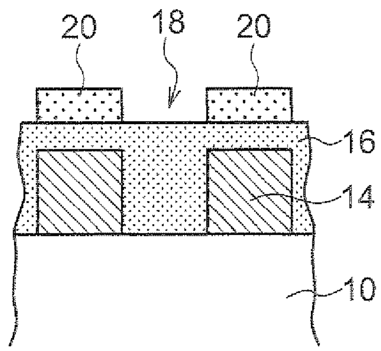


FIG.4C

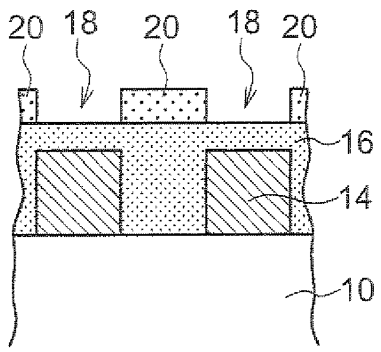

FIG.5A

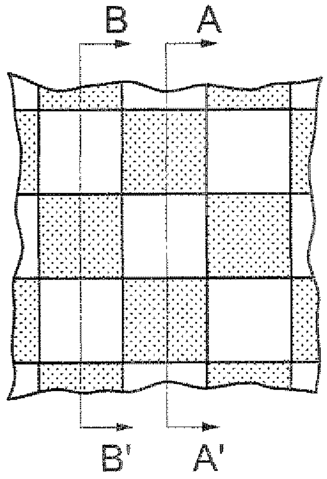


FIG.5B

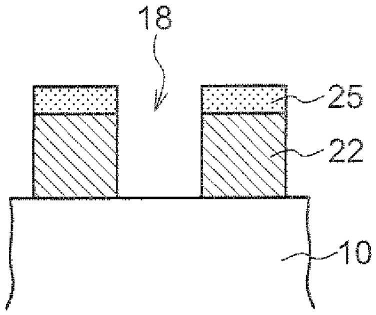


FIG.5C

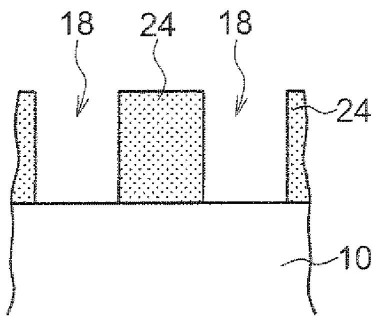

FIG.6A

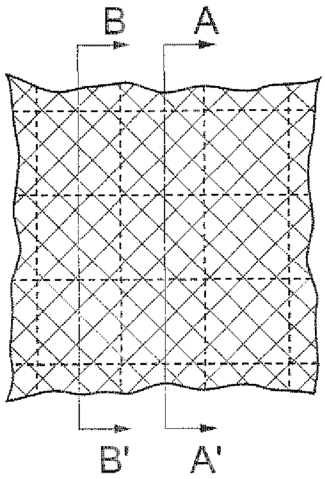


FIG.6B

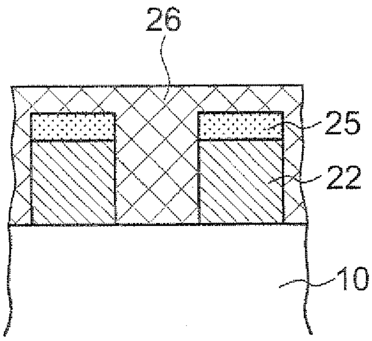


FIG.6C

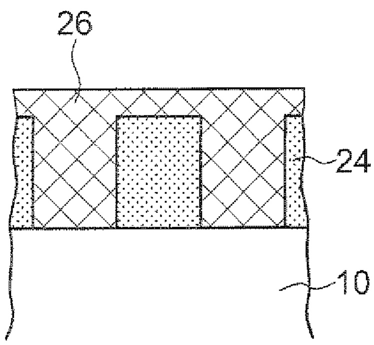

FIG.7A

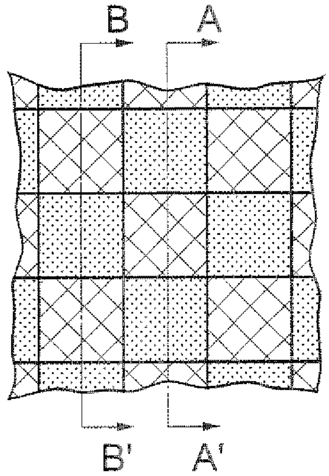


FIG.7B

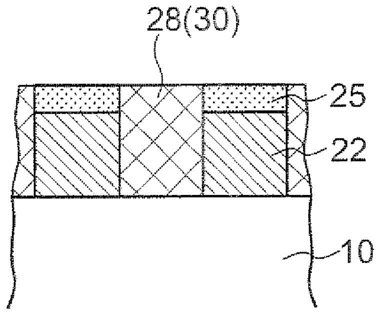


FIG.7C

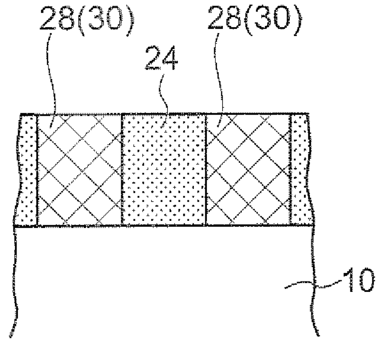

FIG.8A

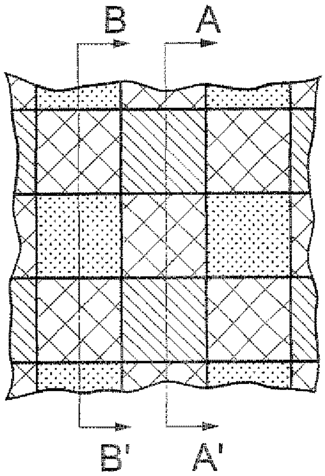


FIG.8B

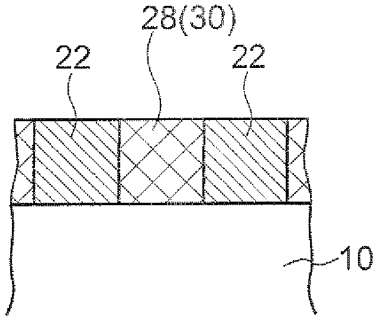


FIG.8C

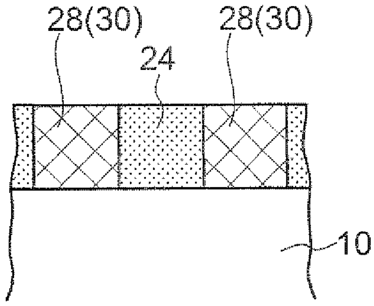

FIG.9A

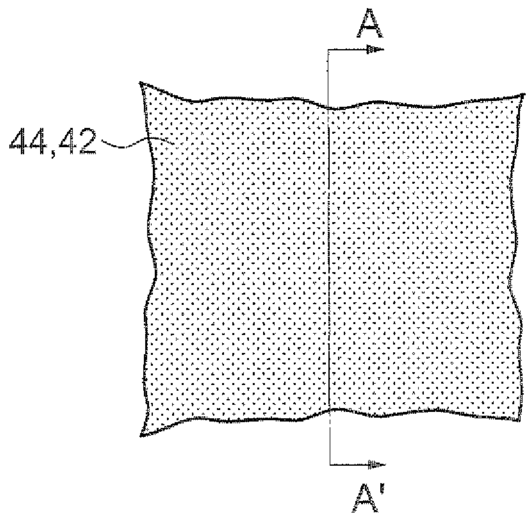


FIG.9B

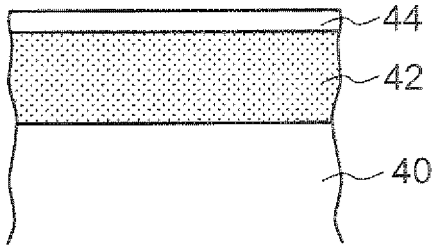

FIG.10A

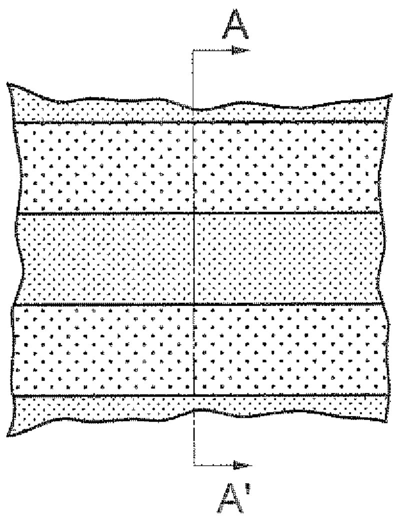


FIG.10B

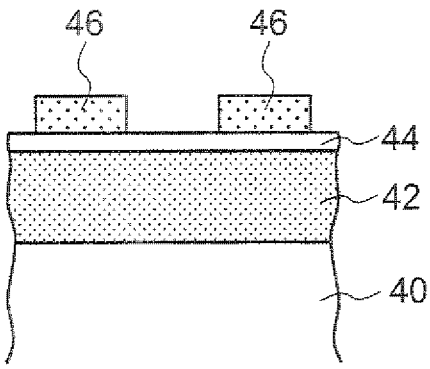

FIG.11A

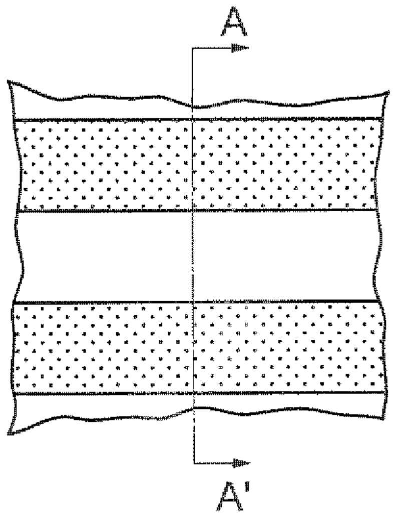


FIG.11B

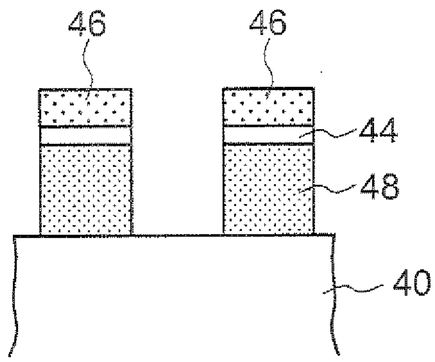

FIG.12A

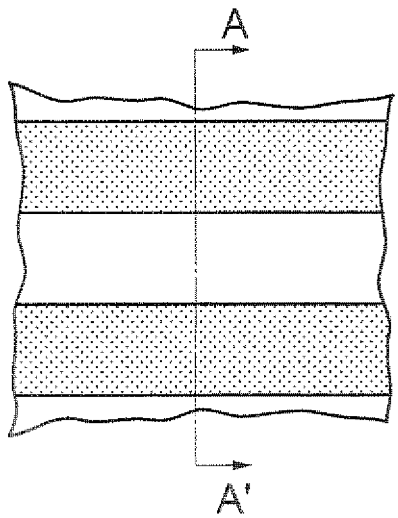


FIG.12B

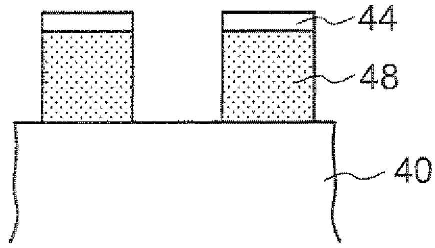

FIG.13A

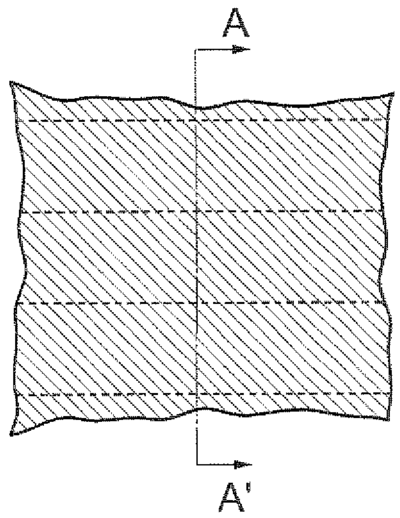


FIG.13B

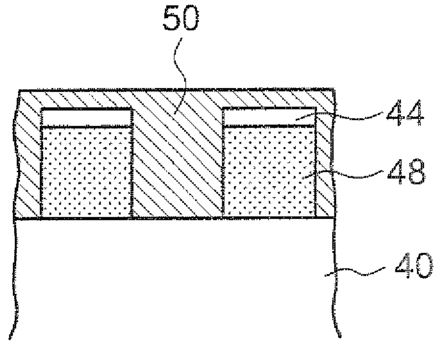

FIG.14A

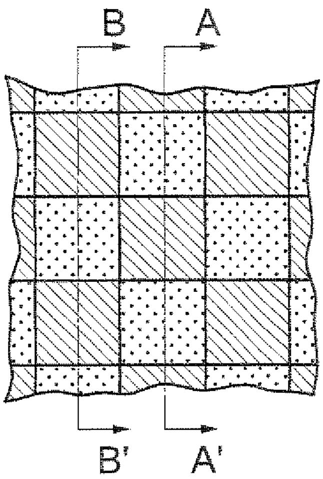


FIG.14B

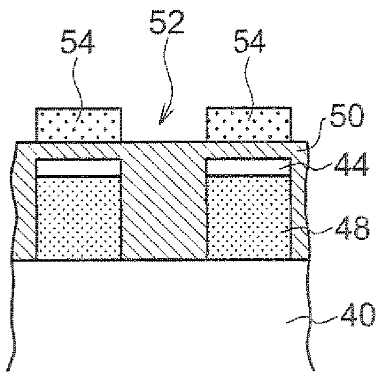


FIG.14C

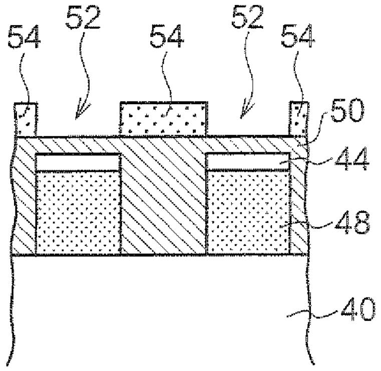

FIG.15A

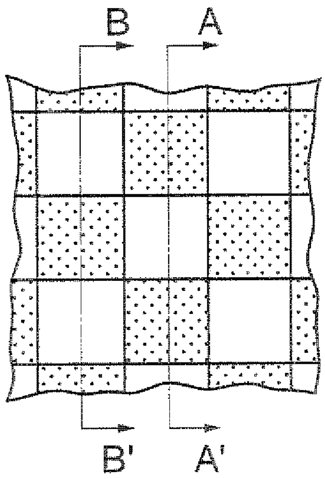


FIG.15B

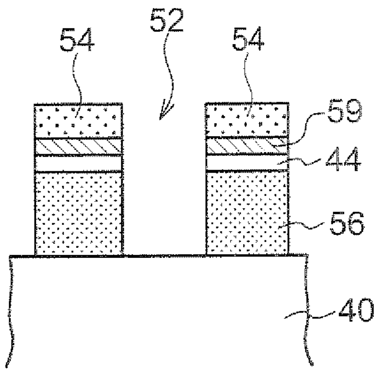


FIG.15C

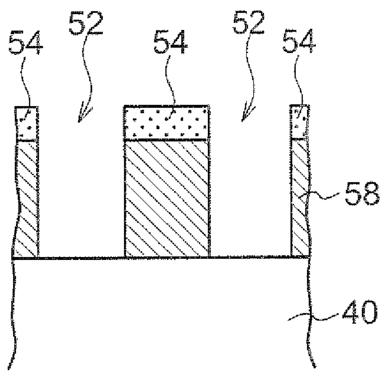

FIG.16A

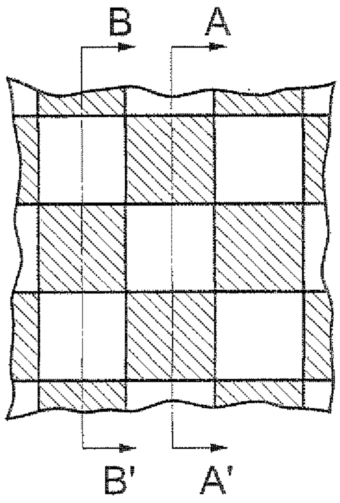


FIG.16B

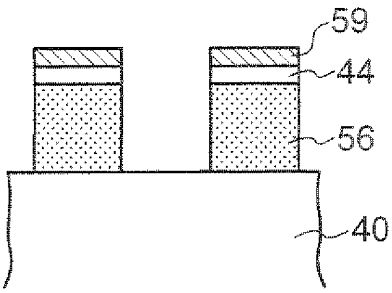


FIG.16C

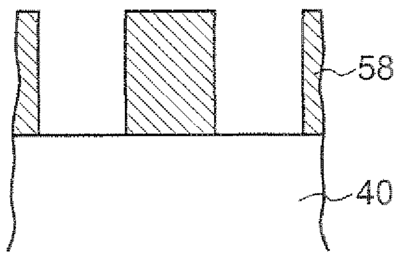

FIG.17A

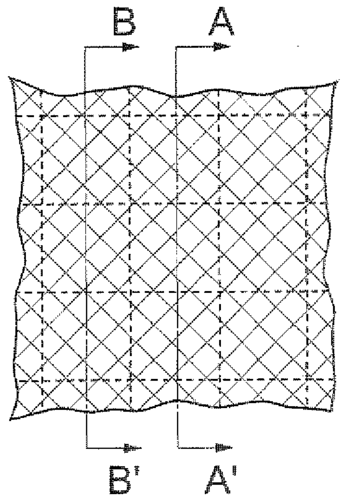


FIG.17B

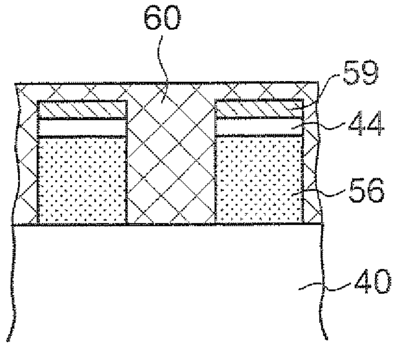


FIG.17C

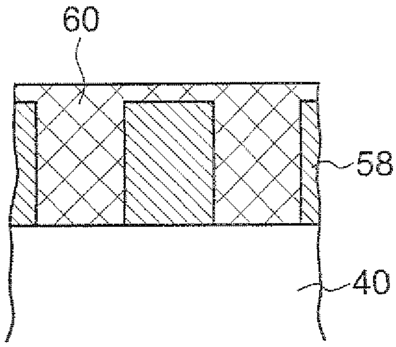

FIG.18A

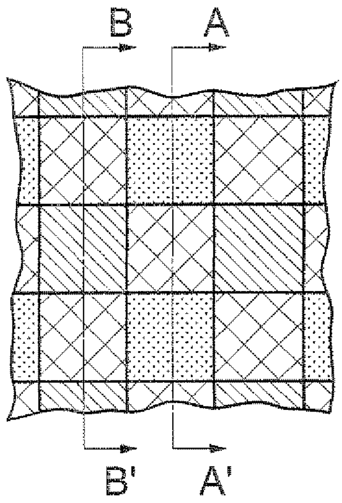


FIG.18B

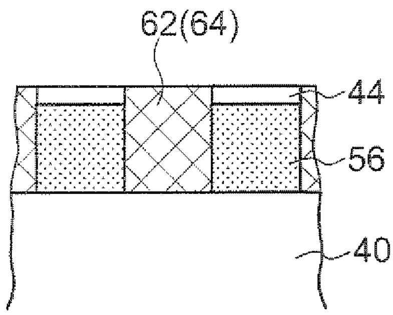


FIG.18C

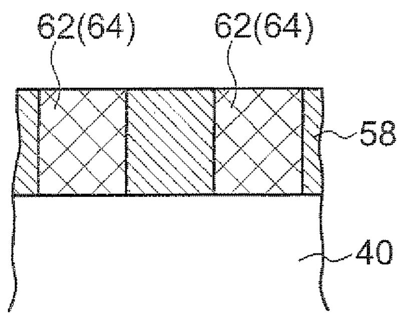

FIG.19

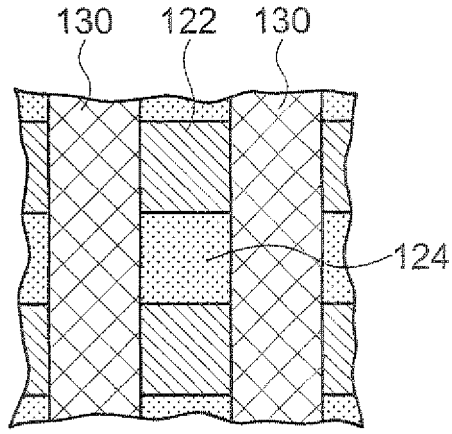

FIG.20A

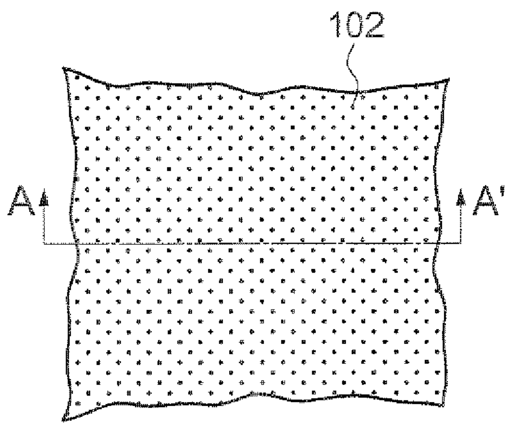


FIG.20B

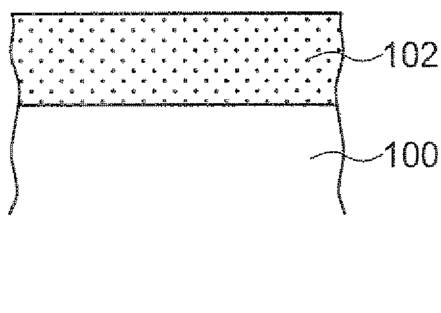

FIG.21A

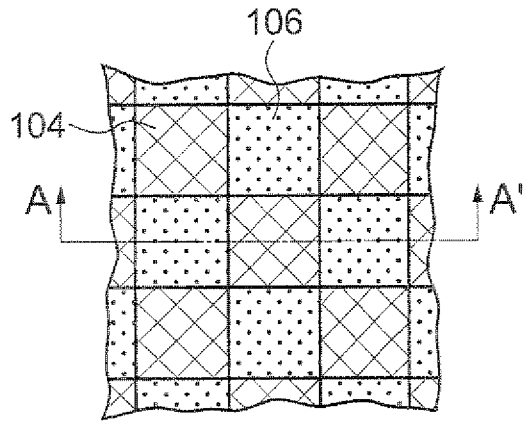


FIG.21B

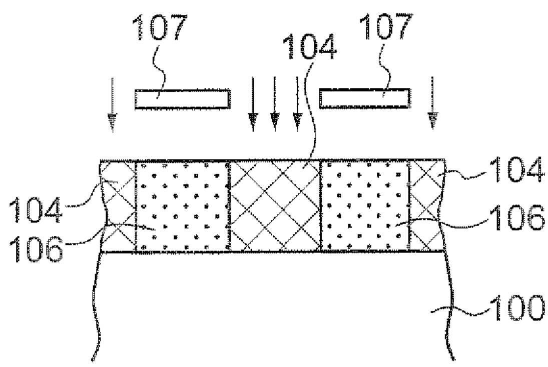

FIG.22A

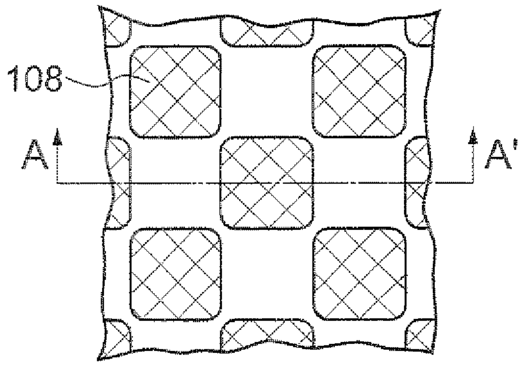


FIG.22B

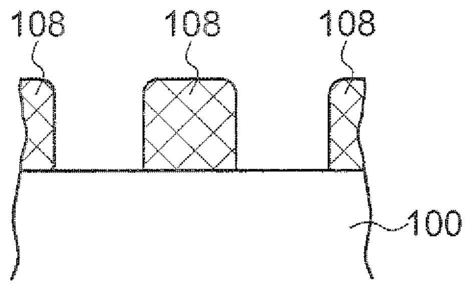

FIG.23A

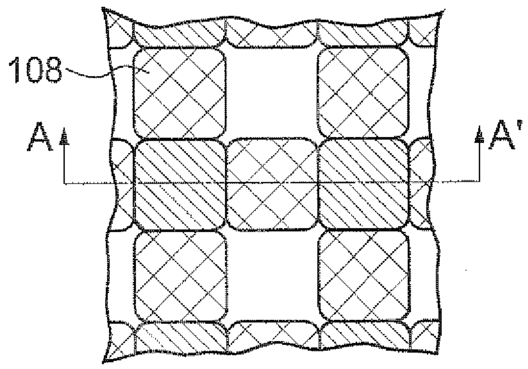


FIG.23B

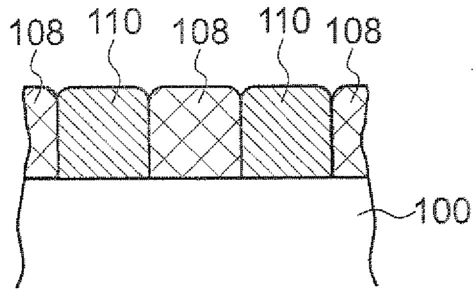

FIG.24A

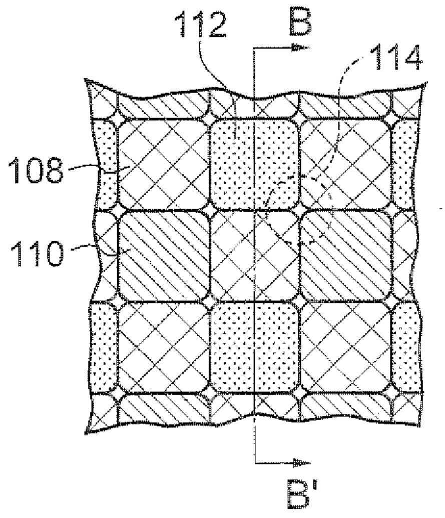


FIG.24B

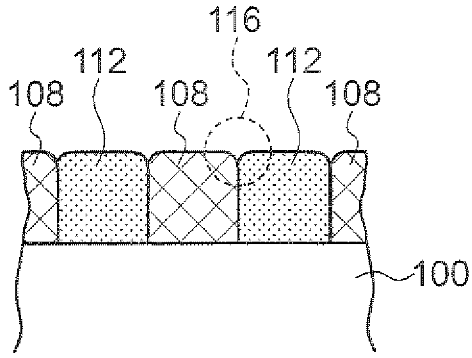

**INTERNATIONAL SEARCH REPORT**

International application No.
PCT/JP2008/073162

A. CLASSIFICATION OF SUBJECT MATTER
*G02B5/20*(2006.01)i

According to International Patent Classification (IPC) or to both national classification and IPC

B. FIELDS SEARCHED

Minimum documentation searched (classification system followed by classification symbols)
G02B5/20

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2009 |
| Kokai Jitsuyo Shinan Koho | 1971-2009 | Toroku Jitsuyo Shinan Koho | 1994-2009 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2007-79154 A (Fujifilm Corp.),<br>29 March, 2007 (29.03.07),<br>Par. Nos. [0001], [0036] to [0048]; Figs. 4 to 15<br>(Family: none) | 1,2,4,7,8<br>3,5,6 |
| X<br>Y | JP 2006-351786 A (Fujifilm Holdings Corp.),<br>28 December, 2006 (28.12.06),<br>Par. Nos. [0001], [0053] to [0065]; Figs. 4 to 15<br>(Family: none) | 1,2,4,7,8<br>3,5,6 |
| X<br>Y | JP 57-4012 A (Canon Inc.),<br>09 January, 1982 (09.01.82),<br>Full text; Figs. 2, 3<br>(Family: none) | 1,2,7,8<br>3-6 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 09 March, 2009 (09.03.09) | 07 April, 2009 (07.04.09) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/073162

C (Continuation). DOCUMENTS CONSIDERED TO BE RELEVANT

| Category* | Citation of document, with indication, where appropriate, of the relevant passages | Relevant to claim No. |
|---|---|---|
| X<br>Y | JP 2003-332310 A (Sony Corp.),<br>21 November, 2003 (21.11.03),<br>Par. Nos. [0029] to [0040]; Figs. 2, 3<br>(Family: none) | 1,2,7,8<br>3-6 |
| X<br>A | JP 2007-324321 A (Fujifilm Corp.),<br>13 December, 2007 (13.12.07),<br>Par. Nos. [0059] to [0070]<br>(Family: none) | 7,8<br>1-6 |
| Y | JP 2007-248662 A (Sharp Corp.),<br>27 September, 2007 (27.09.07),<br>Par. Nos. [0049] to [0053]<br>(Family: none) | 3-5 |
| Y | JP 10-209410 A (Sony Corp.),<br>07 August, 1998 (07.08.98),<br>Claim 1; Fig. 1<br>(Family: none) | 3-5 |
| Y | JP 2003-298034 A (Sony Corp.),<br>17 October, 2003 (17.10.03),<br>Claim 5; Par. Nos. [0043] to [0053]<br>(Family: none) | 5 |
| Y | JP 2005-10280 A (Seiko Epson Corp.),<br>13 January, 2005 (13.01.05),<br>Par. No. [0026]<br>& US 2004/0257541 A1 | 6 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2181704 A
- JP 2199403 A
- JP 5273411 A
- JP 7140654 A
- JP 2006267352 A
- JP 2006292842 A
- JP 2001249218 A
- JP 59126506 A
- JP 59046628 A
- JP 58009108 A
- JP 58002809 A
- JP 57148706 A
- JP 61041102 A
- JP 2005326453 A
- JP 59044615 A
- JP 54034327 B
- JP 58012577 B
- JP 54025957 B
- JP 59053836 A
- JP 59071048 A
- JP 2004294638 A
- JP 2005146182 A